# EUROPEAN PATENT APPLICATION

(11) **EP 1 580 762 A2**
(43) Date of publication of application: **28.09.2005**
(21) Application number: 05251696.0
(22) Date of filing: 19.03.2005
(51) Int. Cl.: G11C 16/04

(54) **Memory cell having an electric field programmable storage element, and method of operating same**

(30) Priority: 24.03.2004 US 556246 P; 13.10.2004 US 964382
(71) Applicant: ROHM AND HAAS COMPANY, Pennsylvania 19106-2399 (US)
(72) Inventor: Greer, Edward C., Lower Gwynedd Pennsylvania 19002 (US); Murphy, Robert J., Los Gatos California 95030 (US); Szmanda, Charles R., Westborough Massachusetts 01581 (US)
(74) Representative: Buckley, Guy Julian

(57) **Abstract**

Disclosed is a memory cell having an access transistor and an electric field programmable bi-stable element. The access transistor may be a (N-channel or P-channel) MOSFET transistor having a gate, source or drain region coupled to the electric field programmable bi-stable or multi-stable element (hereinafter collectively, "bi-stable element" unless expressly indicated otherwise). The access transistor facilitates selective and controllable programming and reading of the electric field programmable bi-stable element. Also disclosed is a plurality of memory cells, each having a unique, different and/or distinct electric field programmable bi-stable element and a common access transistor. In yet another aspect, a differential memory cell having a plurality of memory cells configured to store complementary data states is disclosed. The differential memory cell includes first memory cell and second memory cell wherein the first memory cell maintains a complementary state relative to second memory cell. The first and second memory cells include a common access transistor and unique, different and/or distinct electric field programmable bi-stable element, or each includes an access transistor and an electric field programmable bi-stable element. Finally, a complementary memory cell having an N-channel type memory cell (an N-channel access transistor and an electric field programmable bi-stable element) and a P-channel type memory cell (a P-channel access transistor and an electric field programmable bi-stable element) is disclosed. Additionally, a three-dimensional arrangement of stacking the memory cells is shown.

## Description

### BACKGROUND OF THE INVENTION

This invention relates to a memory cell, array and/or device and method of controlling and/or operating the memory cell, array and/or device; and more particularly, in one aspect, to a memory cell, and array and/or device including a plurality of such memory cells, wherein the memory cells each include an electric field programmable film to store an electrical charge which is representative of a data state.

There are many different types and/or forms of memory cells, arrays and devices. Such devices may be classified generally into two different types, namely volatile (for example, dynamic random access memory ("DRAM") and static random access memory ("SRAM")), and non-volatile (for example, read only memory ("ROM"), electrically programmable read only memory ("EPROM"), and electrically erasable programmable read only memory ("EEPROM")). Conventional memory cells, arrays and devices are typically fabricated in a one plane approach, and presently from inorganic materials such as mono- and poly-crystalline silicon. (See, for example, Published U.S. Patent Application 2004/0135193 and 6,710,384).

Although devices including such memory cells have been technically and commercially successful, they have a number of shortcomings, including, for example, complex architectures, density constraints, and relatively high fabrication costs. Moreover, in the case of some volatile type memory devices, "refresh" circuitry must be incorporated to constantly/periodically re-store information. This may raise issues pertaining to heat dissipation, timing, and power consumption. In addition, although certain integration densities can be achieved, such devices tend to be limited or restricted with respect to the size of the memory cell.

For example, in a conventional DRAM, the memory cell consists of an access transistor, typically built on the surface of a single-crystal silicon wafer, and a capacitor, which is comprised of, for example, two silicon-based conductors separated by a dielectric (for example, an oxide, nitride or combination thereof). The capacitor stores an electric charge representing a bi-stable memory state. The access transistor serves as a switch for controlling the charging and discharging of the capacitor as well as reading and writing of the logic states into the capacitor (i.e., charging or discharging the capacitor). Conventional techniques employ stacked and/or trench capacitor approaches, whereby the capacitor is partially disposed above and/or below an access transistor in an attempt to reduce the two-dimensional area occupied by the memory cell. As such, conventional DRAMs employing one transistor - one capacitor memory cells, tend to be limited or restricted with respect to the size of the memory cell as well as layout to a single plane.

Non-volatile semiconductor devices avoid certain issues prevalent in volatile semiconductor devices but often suffer from reduced data storage capability, capacity and/or density as a result of higher complexity in cell and circuit design. (See, for example, Published U.S. Patent Applications 2004/0135193 and 2004/0136239). The higher complexity often results in higher production costs. For example, in a conventional EEPROM, the memory cell includes a transistor having a plurality of gates disposed above a monocrystalline semiconductor substrate and separated by a thin insulator having a highly controlled thickness. In particular, a control gate is disposed over a floating gate, which is disposed over a channel region within a semiconductor substrate. The floating gate is typically comprised of a heavily doped silicon or metal layer (for example, aluminum) and is separated from the channel region via a highly controlled thin insulator that tends to degrade over usage/time.

In addition to the ubiquitous inorganic crystalline semiconductor based devices, there exist alternative electronic memory and switching devices which employ a bi-stable element that can be converted between a high impedance state and a low impedance state by applying an electrical current or other type of input to the device. Both organic and inorganic thin-film semiconductor materials may be used in electronic memory and switching devices, for example thin films of amorphous chalcogenide semiconductor organic charge-transfer complexes such as copper-7,7,8,8-tetracyanoquinodimethane (Cu-TCNQ) thin films, and certain inorganic oxides in organic matrices. Notably, these materials have been proposed as potential candidates for non-volatile memories.

Several volatile and non-volatile memory elements have been implemented using various bistable materials. However, many currently known bistable films are inhomogeneous, multilayered composite structures fabricated by evaporative methods, which are expensive and often difficult to control. In addition, these bistable films do not afford the opportunity for fabricating films in topographies ranging from conformal to planar. Bistable films fabricated using polymer matrices and particulate matter are generally inhomogeneous and therefore unsuitable for fabricating submicrometer and nanometer-scale electronic memory and switching devices.

Still other bistable films can be controllably manufactured by standard industrial methods, but their operation requires high temperature melting and annealing at grid intersection points. Such films generally suffer from thermal management problems, have high power consumption requirements, and afford only a small degree of differentiation between the "conductive" and "nonconductive" states. Furthermore, because such films operate at high temperatures, it is difficult to design stacked device structures that allow high density memory storage.

Accordingly, there remains a need for an improved memory cell, array and/or device employing electric field programmable bistable films that overcomes one, some and/or all of the shortcomings of the conventional memory cells, arrays, and/or devices employing conventional bistable films. There is a need for an improved memory cell, array and/or device, implementing electric field programmable bistable films, which include or are suitable for a variety of substrates and a variety of definable topographies, including single plane and/or multiple plane architectures.

Further, there is a need for memory cells, arrays and/or devices, employing electric field programmable bistable films, which may be manufactured more easily and readily using conventional integrated circuit fabrication techniques. Moreover, there is a need for memory cells, arrays and/or devices, implementing electric field programmable bistable films, which are relatively less expensive (for example, on a per bit basis) than conventional memory cells, arrays and/or devices. In addition, there is a need for memory cells, arrays, and /or devices, implementing these field electric programmable bi-stable films as embedded with logic or other circuitry, which requires fewer integration steps and/or masks to fabricate.

### SUMMARY OF THE INVENTION

In a first aspect, disclosed is a memory cell having at least a first data state and a second data state, the memory cell comprising a semiconductor transistor (for example, a P-channel or an N-channel transistor) and an electric field programmable bi-stable element, which is connected to the semiconductor transistor. In one embodiment, the semiconductor transistor includes first and second regions, each having impurities to provide a first conductivity type. The semiconductor transistor also includes a body region disposed between the first region and the second region, wherein the body region includes impurities to provide a second conductivity type (wherein the second conductivity type is different from the first conductivity type). A gate is spaced from, and electrically coupled to the body region.

The electric field programmable bi-stable element of the memory cell includes first and second electrodes and at least one electric field programmable film disposed between the first and second electrodes wherein the first data state of the memory cell is representative of a first resistance of the electric field programmable film and the second data state is representative of a second resistance of the electric field programmable film.

In one embodiment, the first electrode is connected to the first region, which is a drain region of the transistor. In another embodiment, the first electrode is connected to the second region, which is a source region of the transistor. In yet another embodiment, the first electrode is connected to the gate of the semiconductor transistor.

The first electrode may be disposed on the first region of the semiconductor transistor. Moreover, the first electrode may be disposed on the first region of the semiconductor transistor and extend over (either above or below) at least a portion of the gate. Indeed, the first electrode may be at least a portion of the first region of the semiconductor transistor.

In one embodiment of this aspect of the invention, the first electrode is disposed on the gate of the semiconductor transistor. In another embodiment, the first electrode is the gate of the semiconductor transistor.

In another aspect, disclosed is a memory cell (having at least first data state and a second data state) including a transistor and a plurality of electric field programmable bi-stable elements, which are connected to the transistor. In one embodiment, the semiconductor transistor includes first and second regions, each having impurities to provide a first conductivity type. The semiconductor transistor also includes a body region disposed between the first region and the second region, wherein the body region includes impurities to provide a second conductivity type (wherein the second conductivity type is different from the first conductivity type). A gate is spaced from, and electrically coupled to the body region. Notably, the semiconductor transistor may be a P-channel or an N-channel transistor.

The memory cell of this aspect further includes first and second electric field programmable bi-stable elements which are connected to the semiconductor transistor. Each electric field programmable bi-stable element includes a first electrode, a second electrode and at least one electric field programmable film disposed between the first and second electrodes. The electric field programmable film includes at least two resistance states, including a first resistance state and a second resistance state.

The memory cell of this aspect is in the first data state when the electric field programmable film of the first electric field programmable bi-stable element is in the first state and the electric field programmable film of the second electric field programmable bi-stable element is in the second state. The memory cell is in the second data state when the electric field programmable film of the first electric field programmable bi-stable element is in the second state and the electric field programmable film of the second electric field programmable bi-stable element is in the first state.

In one embodiment of this aspect, the first region is a drain region of the semiconductor transistor and the first electrode of the first electric field programmable bi-stable element is connected to the drain region. In another embodiment, the second region is a source region of the semiconductor transistor and the first electrode of the first electric field programmable bi-stable element is connected to the source region.

Further, in one embodiment, the first electrode of the first electric field programmable bi-stable element is disposed on the first region of the semiconductor transistor. In another embodiment, the first electrode of the first electric field programmable bi-stable element is disposed on the first region of the semiconductor transistor and extends above the gate of the semiconductor transistor. The first electrode may also be a portion of the first region of the semiconductor transistor.

The memory cell may include third and fourth data states. In this regard, the memory cell is in the third data state when the electric field programmable film of the first electric field programmable bi-stable element is in the first state and the electric field programmable film of the second electric field programmable bi-stable element is in the first state. The memory cell is in the fourth data state when the electric field programmable film of the first electric field programmable bi-stable element is in the second state and the electric field programmable film of the second electric field programmable bi-stable element is in the second state.

In yet another aspect, a memory cell (having at least first and second data states) including a plurality of semiconductor transistors and a plurality of electric field programmable bi-stable elements. The memory cell comprises a first semiconductor transistor including first and second regions, each having impurities to provide a first conductivity type. The first semiconductor transistor also includes a body region disposed between the first region and the second region, wherein the body region includes impurities to provide a second conductivity type (wherein the second conductivity type is different from the first conductivity type). A gate is spaced from, and electrically coupled to the body region of the first semiconductor transistor.

The memory cell also includes a first electric field programmable bi-stable element which is connected to the first semiconductor transistor. The electric field programmable bistable element includes first and second electrodes and at least one electric field programmable film disposed between the first and second electrodes. The electric field programmable film includes at least two resistance states, including a first resistance state and a second resistance state.

In addition, the memory cell of this aspect includes a second semiconductor transistor. The second semiconductor transistor includes first and second regions, each having impurities to provide a first conductivity type, and a body region disposed between the first region and the second region. The body region includes impurities to provide a second conductivity type (wherein the second conductivity type is different from the first conductivity type). A gate is spaced from, and electrically coupled to the body region of the second semiconductor transistor.

The memory cell of this aspect also includes a second electric field programmable bistable element which is connected to the second semiconductor transistor. The second electric field programmable bi-stable element includes first and second electrodes and at least one electric field programmable film disposed between the first and second electrodes. The electric field programmable film of the second electric field programmable element includes at least two resistance states, including a first resistance state and a second resistance state.

The memory cell is in, the first data state when the electric field programmable film of the first electric field programmable bi-stable element is in the first state and the electric field programmable film of the second electric field programmable bi-stable element is in the second state. The memory cell is in the second data state when the electric field programmable film of the first electric field programmable bi-stable element is in the second state and the electric field programmable film of the second electric field programmable bi-stable element is in the first state.

Notably, the memory cell is in a third data state when the electric field programmable film of the first electric field programmable bi-stable element is in the second state and the electric field programmable film of the second electric field programmable bi-stable element is in the second state. Moreover, the memory cell is in the fourth data state when the electric field programmable film of the first electric field programmable bi-stable element is in the first state and the electric field programmable film of the second electric field programmable bi-stable element is in the first state.

In one embodiment, the first semiconductor transistor is an N-channel transistor and the second transistor is a P-channel transistor. In another embodiment, the first semiconductor transistor is an N-channel transistor and the second transistor is an N-channel transistor. In yet another embodiment, the first semiconductor transistor is a P-channel transistor and the second transistor is a P-channel transistor.

In one embodiment, the first electrode of the first electric field programmable bistable element is connected to the first region of the first semiconductor transistor, which is a drain region of the first semiconductor transistor. In another embodiment, the first electrode of the first electric field programmable bi-stable element is connected to the second region of the first semiconductor transistor, which is a source region of the first semiconductor transistor. In yet another embodiment, the first electrode of the first electric field programmable bi-stable element is connected to the gate of the first semiconductor transistor.

The first electrode of the first electric field programmable bi-stable element may be disposed on the first region of the first semiconductor transistor. Moreover, the first electrode of the first electric field programmable bi-stable element may be disposed on the first region of the semiconductor transistor and extend over (either above or below) at least a portion of the gate. Indeed, the first electrode of the first electric field programmable bi-stable element may be at least a portion of the first region of the semiconductor transistor.

In one embodiment of this aspect, the first electrode of the first electric field programmable bi-stable element is disposed on the gate of the first semiconductor transistor. In another embodiment, the first electrode of the first electric field programmable bi-stable element is the gate of the first semiconductor transistor.

### BRIEF DESCRIPTION OF THE DRAWINGS

In the course of the detailed description to follow, reference will be made to the attached drawings. These drawings show different aspects of the present invention and, where appropriate, reference numerals illustrating like structures, components, materials and/or elements in different figures are labeled similarly. It is understood that various combinations of the structures, components, materials and/or elements, other than those specifically shown, are contemplated and are within the scope of the present invention.

FIGURES 1A-1C are exemplary schematic illustrations of three embodiments of memory cells, each including an access transistor and an electric field programmable bi-stable film element, according to an aspect of the present invention;

FIGURE 2 is a graphical representation of the current-voltage switching characteristics of an electric field programmable bi-stable film element, including an exemplary electric field programmable bi-stable film, according to one embodiment of the present invention;

FIGURES 3A-3C are cross-sectional views of a plurality of exemplary layouts of a memory cell according to certain embodiments of one aspect of the present invention, wherein the electric field programmable bi-stable film element is coupled to the source or drain region of the access transistor as illustrated in the schematic representation of FIGURE 1A; notably, FIGURE 3A is sectioned along dotted line A-A of FIGURE 4;

FIGURE 4 illustrates a top view of an exemplary layout of the memory cell schematically represented in FIGURE 1A;

FIGURES 5A and 5B are cross-sectional views of a plurality of exemplary layouts of the memory cell, wherein the electric field programmable bi-stable film element is coupled to the gate of the access transistor as illustrated in the schematic representation of FIGURE 1B, in accordance with certain embodiments of the present invention;

FIGURE 6A is an exemplary schematic illustration of a memory cell of one embodiment of the present invention, in conjunction with a read or sense amplifier and memory cell selection circuitry, according to an embodiment of the present invention;

FIGURE 6B is an exemplary schematic illustration of a memory cell of one embodiment of the present invention (schematically illustrated in FIGURE 1A), in conjunction with a programming circuitry and memory cell selection circuitry, according to an embodiment of the present invention;

FIGURE 7A illustrates exemplary waveforms of control signals to read the data state stored in a memory cell of an embodiment of the present invention (schematically illustrated in FIGURE 1A), according to embodiments of the present invention;

FIGURE 7B illustrates exemplary waveforms of control signals to write the data state stored in a memory cell of an embodiment of the present invention (schematically illustrated in FIGURE 1A), according to embodiments of the present invention;

FIGURE 7C illustrates exemplary waveforms of programming control signals to erase the data state in a memory cell of an embodiment of the present invention (schematically illustrated in FIGURE 1A), according to embodiments of the present invention;

FIGURE 7D illustrates exemplary waveforms of programming control signals to erase the data state in a memory cell of an embodiment of the present invention (schematically illustrated in FIGURE 1A), according to other embodiments of the present invention;

FIGURE 8A is a block diagram representation of a memory array, including peripheral circuitry and a plurality of memory cells, according to one embodiment of the present invention;

FIGURE 8B illustrates a block diagram schematic representation of a memory array, including a plurality of sub-arrays according to certain embodiments of the present invention;

FIGURE 9 is a schematic representation of a plurality of memory cells, comprised of an access transistor that is shared between a plurality of electric field programmable bi-stable film elements, each of which is coupled to the source or drain region of the control transistor, in accordance with one embodiment of another aspect of the present invention;

FIGURES 10A and 10B are cross-sectional views of a plurality of exemplary layouts of the memory cells of FIGURE 9, wherein a plurality of electric field programmable bi-stable film elements are disposed in a plurality of stacked layers and are coupled to the source or drain region of the access transistor, in accordance with certain embodiments of the present invention;

FIGURES 11A and 11B illustrate block diagram schematic representation of a memory array, having a plurality of stacked layers of the electric field programmable film, according to certain embodiments of the present invention;

FIGURE 11B is a block diagram representation of a memory array, "effectively" including a plurality of memory cells in each layer of the memory array, according to one embodiment of the present invention;

FIGURE 12A illustrates schematic representations of exemplary embodiments of the programming circuitry for the memory cells of FIGURE 9, in accordance with embodiments of certain aspects of the present invention;

FIGURE 12B illustrates a schematic representation of an exemplary embodiment of read or sense circuitry for the memory cells of FIGURE 9, in accordance with embodiments of certain aspects of the present invention;

FIGURES 12C and 12D illustrate two schematic representations of exemplary embodiments of read or sense circuitry for the memory cells of FIGURE 9, in accordance with certain embodiments of the present invention;

FIGURE 13 is a schematic representation of a plurality of memory cells, comprised of an access transistor that is shared between a plurality of electric field programmable bi-stable film elements, which are stacked in a plurality of layers and are coupled to the gate of the control transistor, in accordance with another embodiment of another aspect of the present invention;

FIGURES 14A and 14B are cross-sectional views of a plurality of exemplary layouts of the memory cells of FIGURE 13, wherein a plurality of electric field programmable bi-stable film elements are stacked in a plurality of layers and are coupled to the gate of the access transistor, in accordance with certain embodiments of the present inventions;

FIGURES 15A and 15B illustrate schematic representations of exemplary embodiments of programming circuitry for the memory cells of FIGURE 13, in accordance with embodiments of certain aspects of the present invention;

FIGURE 15C illustrates a schematic representation of an exemplary embodiment of read or sense circuitry for the memory cells of FIGURE 13, in accordance with embodiments of certain aspects of the present invention;

FIGURE 16 is a schematic representation of a differential memory cell, including first and second memory cells, each having an access transistor and electric field programmable bi-stable film element, according to certain embodiments of another aspect of the present inventions;

FIGURE 17A illustrates a schematic representation of an exemplary embodiment of the read or sense circuitry for the memory cell of FIGURE 16, in accordance with embodiments of certain aspects of the present invention;

FIGURE 17B illustrates a schematic representation of an exemplary embodiment of the programming circuitry for the memory cell of FIGURE 16, in accordance with embodiments of certain aspects of the present invention;

FIGURES 18A-18C are schematic representations of other embodiments of differential memory cell, including first and second memory cells, each having an access transistor and electric field programmable bi-stable film element, according to certain embodiments of another aspect of the present inventions;

FIGURE 19 is a schematic representation of yet another embodiment of differential memory cell, including first and second memory cells, which share an access transistor, according to another aspect of the present inventions;

FIGURE 20A illustrates a schematic representation of an exemplary embodiment of the read or sense circuitry for the memory cell of FIGURE 19, in accordance with embodiments of certain aspects of the present invention;

FIGURE 20B illustrates a schematic representation of an exemplary embodiment of the programming or erase circuitry for the memory cell of FIGURE 19, in accordance with embodiments of certain aspects of the present invention;

FIGURE 21A-21E are schematic representations of a complementary (dual or multibit) memory cell, including first memory cell having a N-channel access transistor and electric field programmable bi-stable film element and a second memory cell having a P-channel access transistor and electric field programmable bi-stable film element, according to certain embodiments of another aspect of the present inventions;

FIGURES 22A illustrates block diagram schematic representation of a memory array including a plurality of differential memory cells of, for example, FIGURE 16 and 18A-18C, wherein the memory array is comprised of a plurality of stacked layers of the electric field programmable film and "effectively" including a plurality of memory cells in each layer of the memory array, according to one embodiment of the present invention;

FIGURE 22B is a block diagram representation of a memory array including a plurality of differential memory cells of, for example, FIGURE 16 and 18A-18C, wherein the memory array is comprised of one layer of the electric field programmable film, according to one embodiment of the present invention;

FIGURES 22C illustrates block diagram schematic representation of a memory array including a plurality of complementary memory cells of, for example, FIGURES 19A-19C, wherein the memory array is comprised of a plurality of stacked layers of the electric field programmable film and "effectively" including a plurality of memory cells in each layer of the memory array, according to one embodiment of the present invention;

FIGURE 22D is a block diagram representation of a memory array including a plurality of complementary memory cells of, for example, FIGURES 19A-19C, wherein the memory array is comprised of one layer of the electric field programmable film, according to one embodiment of the present invention;

FIGURES 23A-23C illustrate exemplary three-dimensional memory arrays, according to one embodiment of the present invention, wherein access transistors are fabricated in one or more layers (in addition to or in lieu of the substrate) and electric field programmable bi-stable elements may be formed, disposed and/or located in layers or planes that are above and/or below the access transistors.

### DETAILED DESCRIPTION OF THE INVENTION

In a first aspect, disclosed is a memory cell having an access transistor and an electric field programmable bi-stable element. The access transistor may be a (N-channel or P-channel) MOSFET transistor having a gate, source or drain region coupled to the electric field programmable bi-stable or multi-stable element (hereinafter collectively, "electric field programmable bi-stable element", unless expressly indicated otherwise). The access transistor facilitates selective and controllable programming and reading of the electric field programmable bi-stable element.

In one embodiment, the electric field programmable bi-stable element provides two or more different resistance characteristics; each resistance characteristic is representative of one data state (for example, an analog or digital state). The electric field programmable bi-stable element may be comprised of one or more electric field programmable films including an electron donor and/or an electron acceptor and/or an electron donor-acceptor complex. The complex may be disposed between two or more electrodes.

The electric field programmable bi-stable element provides a resistance to current flow which is representative of the data state of the memory cell. The field programmable bistable element is programmed in one of the data states via application of a suitable voltage to at least one of the electrodes, inducing an electric field which, in turn, causes, for example, the electron donor and/or an electron acceptor and/or an electron donor-acceptor within the complex to exchange charge, align, re-align, arrange or re-arrange in such a manner which is indicative of one of the data states.

The electric field programmable bi-stable element may employ one or more of the electric field programmable films described and illustrated in the literature, such as in U.S. Provisional Application Serial No. 60/556,246, entitled "Memory Devices based on Electric Field Programmable Films", filed March 24, 2004; WO 2004070789, entitled "Rewritable Nano-Surface Organic Electrical Bistable Devices"; *Nature Material* (2204) 3(12), 918-922, entitled "Programmable Polymer Thin Film and Non-Volatile Memory Device"; and *Applied Physics Letters* (2003), 82(9), 1419-1421, entitled "Nonvolatile Electrical Bistability of Organic/Metal - Nanocluster/Organic System". These references may be consulted for typical processes for the manufacture of electric field programmable films.

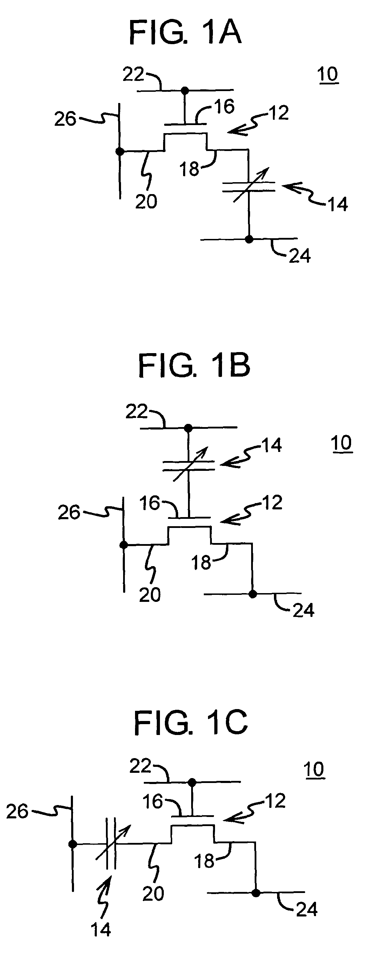

With reference to FIGURES 1A-1C, memory cell 10 of a first aspect of the present invention includes an access transistor 12 and electric field programmable bi-stable element 14. The access transistor 12 includes a gate 16, source 18 and drain 20. In the exemplary embodiment, a body region is disposed between source 18 and drain 20 and is spaced from gate 16. The gate 16 is electrically coupled, for example, directly, capacitively and/or inductively, to the body region of access transistor 12.

In certain embodiments, gate 16 of access transistor 12 is connected to signal line 22, which provides a control signal to access transistor 12 to facilitate reading data from or writing data into electric field programmable bi-stable element 14. (See, for example, FIGURE 1A and 1C). In this regard, the control signal applied on signal line 22 controls the "on" and "off" state of transistor 12.

In other embodiments, gate 16 is connected to electric field programmable bi-stable element 14 (See, for example, FIGURE 1B), which is connected to gate 16 of access transistor 12. In this embodiment, the signal applied on signal line 22 is applied directly to field programmable bi-stable element 14 to facilitate reading data from or writing data into electric field programmable bi-stable element 14.

The source 18 of access transistor 12 may be connected to field programmable bistable element 14 to permit reading data from or writing data into electric field programmable bistable element 14. (See FIGURE 1A). In certain embodiments, source 18 of access transistor 12 is connected to signal line 24, which provides, for example, a reference voltage to memory cell 10. (See, for example, FIGURES 1B and 1C).

With reference to FIGURES 1A and 1C, in certain embodiments, drain 20 of access transistor 12 is connected to sense/program signal line 26, which is selectively and controllably connected to read/write circuitry (not illustrated). In another embodiment, drain 20 is connected to electric field programmable bi-stable element 14, which is connected to sense/program signal line 26. (See, for example, FIGURE 1C). In the embodiments of FIGURES 1A-1C, the data state (i.e., the resistance to current flow presented by electric field programmable bi-stable element 14) is stored in or read from memory cell 10 via sense/program signal line 26.

Notably, access transistor 12 may be a symmetrical or non-symmetrical device. Where access transistor 12 is symmetrical, source 18 and drain 20 are essentially interchangeable. However, where access transistor 12 is a non-symmetrical device, source 18 or drain 20 of access transistor 12 have different electrical, physical, doping concentration and/or doping profile characteristics. As such, the source or drain regions of a non-symmetrical device are typically not interchangeable.

As mentioned above, electric field programmable bi-stable element 14 may be one or more of the electric field programmable films described and illustrated in the Electric Field Programmable Films Patent Application. In one embodiment, electric field programmable bistable element 14 provides for non-destructive reading and includes bi-stable switching or bistable resistance properties. Moreover, electric field programmable bi-stable element 14 provides a non-volatile memory cell in that with the absence of power, the data state of the memory cell is retained in electric field programmable bi-stable element 14.

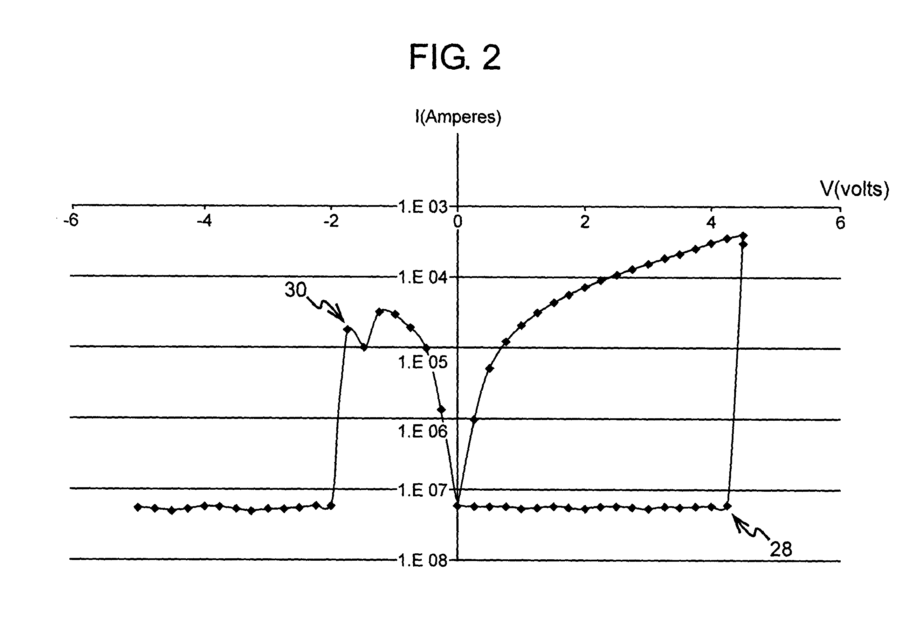

With reference to FIGURE 2, in one exemplary embodiment, electric field programmable bi-stable element 14 is programmed to a first data state (thereby presenting first resistive characteristics) when a first voltage is applied across electric field programmable bistable element 14. (See point 28 in FIGURE 2). The electric field programmable bi-stable element 14 is programmed in a second data state (thereby presenting a second resistive characteristic), or "erases" the first data state, when a second voltage is applied across electric field programmable bi-stable element 14. (See point 30 in FIGURE 2). The electric field programmable bi-stable element 14 remains in the second data state (having second resistive characteristics) until the first voltage is again applied across electric field programmable bi-stable element 14. (See point 28).

In the first data state, electric field programmable bi-stable element 14 provides a relatively low resistance to electrical current flow; and in the second data state, electric field programmable bi-stable element 14 provides a relatively high resistance to electrical current flow.

There are many materials and techniques to fabricate memory cell 10, including access transistor 12 and electric field programmable bi-stable element 14. For example, where the substrate is a bulk-type silicon wafer, access transistor 12 may include source 18 (having impurities of a first conductivity type) and drain 20 (having impurities of a first conductivity type) and a body region (having impurities of a second conductivity type). The gate 16 (a conductive-type material, for example, a metal, metal compound or heavily doped polysilicon) is electrically coupled (for example, directly, capacitively and/or inductively) to the body region. The access transistor 12 may be fabricated using conventional materials and conventional semiconductor manufacturing techniques.

Alternatively, the substrate may be a Silicon-on-Insulator (SOI) type wafer, access transistor 12 may be a partially depleted (PD) transistor, fully depleted (FD) transistor, multiple gate transistor (for example, double or triple gate) and/or fin-shaped field effect transistor ("Fin-FET"). In these embodiments, access transistor 12 may also be fabricated using conventional materials and conventional semiconductor manufacturing techniques.

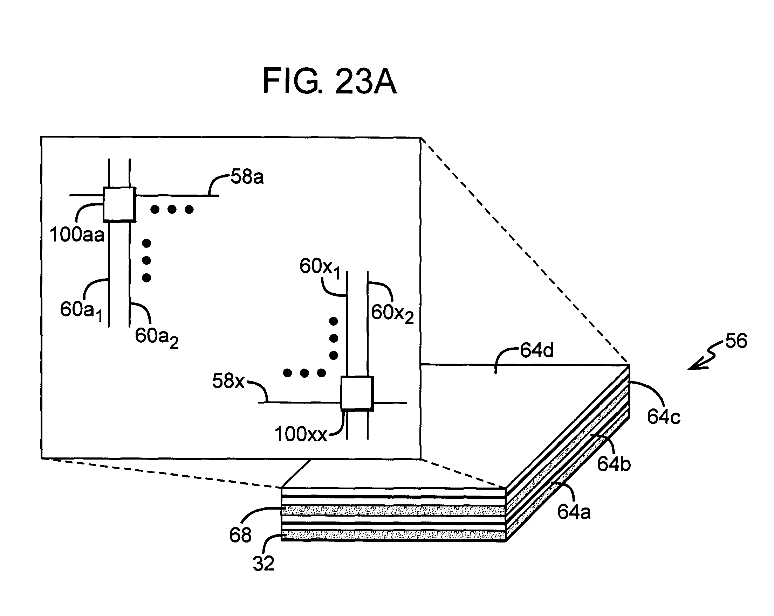

The transistor 12 may also be fabricated from or in polysilicon or amorphous silicon. In this way, a 3-dimensional array of memory may be fabricated wherein one or more layers (in addition to or in lieu of the substrate) may include transistors. (See, for example, layers 68 in FIGURES 23A-23C). Indeed, it may be advantageous to re-crystallize a polysilicon layer disposed above the substrate in order to enhance the operating characteristics of a transistor disposed or fabricated therein. In this way, a 3-dimensional array of memory may include one or more monocrystalline silicon or semiconductor layers (in addition to or in lieu of the substrate) having transistors disposed or fabricated in such layers.

Notably, as mentioned below, transistor 12 may be fabricated from any semiconducting material, organic or inorganic, including for example, silicon carbide, gallium arsenide, or pentacene. The transistor may be operated in depletion mode or enhancement mode. The transistor may also be fabricated with or without a junction. All methods of fabricating transistor 12 (and materials used therein), whether now known or later developed, are intended to be within the scope of the present invention.

The electric field programmable bi-stable element 14 may be fabricated using, for example, any of the electric field programmable films described in the references cited above.

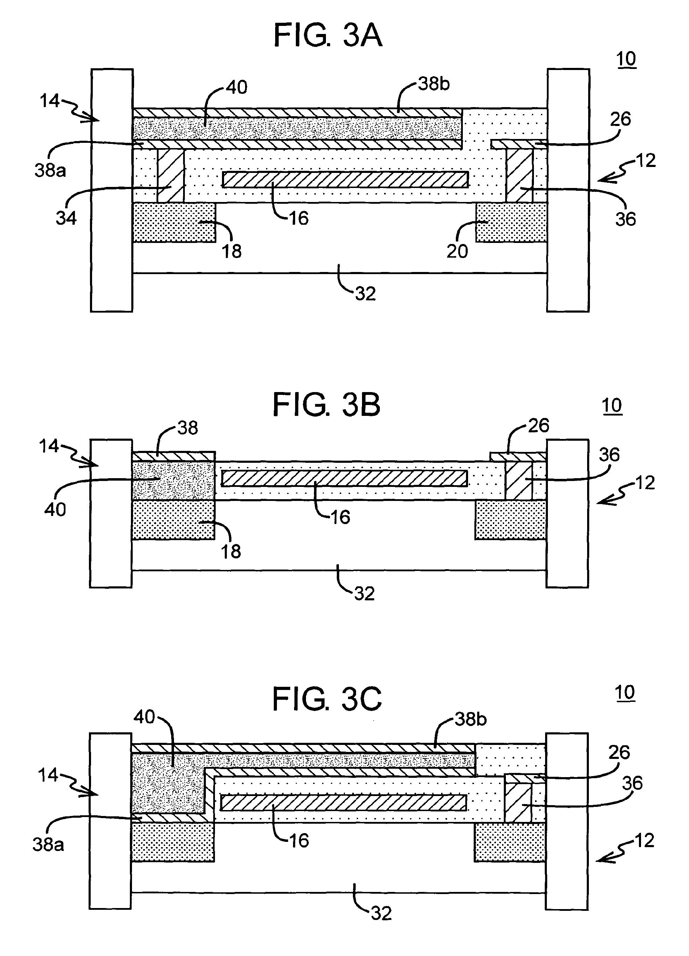

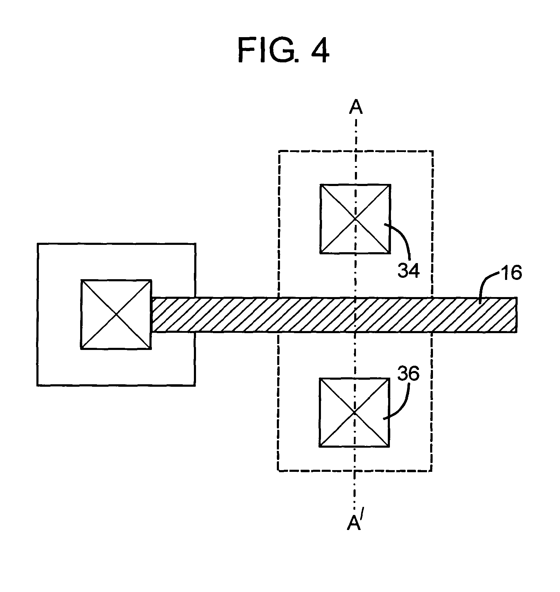

In addition to the materials and fabrication techniques, memory cell 10 may arranged via a number of layouts and configurations. For example, with reference to FIGURES 3A-3C, memory cell 10, illustrated schematically in FIGURE 1A, may be fabricated using different materials, techniques and layouts. In particular, with reference to FIGURES 3A and 4, in one embodiment, memory cell 10 is fabricated in and/or on a bulk-type semiconductor wafer 32. As mentioned above, access transistor 12 may be fabricated from, and using well known or conventional materials and techniques.

After fabrication of access transistor 12, contacts 34 and 36, and sense/program signal line 26 may be formed and/or patterned using conventional well known materials (for example, aluminum or highly doped polysilicon) and conventional deposition, lithographic and etching techniques. Thereafter (or concurrently with the formation of sense/program signal line 26), electrode 38a of electric field programmable bi-stable element 14 may be formed and/or patterned. The electrode 38a may be a conductive-type material (for example, a heavily doped semiconductor (for example, polysilicon) or metal such as aluminum, chromium, gold, silver, molybdenum, platinum, palladium, tungsten, titanium, and/or copper). The electrode 38a may be deposited, formed and/or patterned using conventional or well-known fabrication techniques.

The electric field programmable film 40 may then be deposited on electrode 38a using any of the techniques described in Electric Field Programmable Films Patent Application. Thereafter, electrode 38b may be deposited. As with electrode 38a, electrode 38b may be a conductive-type material (for example, a heavily doped semiconductor (for example, polysilicon) or metal such as aluminum, chromium, gold, silver, molybdenum, platinum, palladium, tungsten, titanium, and/or copper). The electrode 38b may be deposited, formed and/or patterned using conventional fabrication techniques.

As such, in this embodiment, electric field programmable bi-stable element 14 includes electric field programmable film 40 disposed between electrodes 38a and 38b. The contact 34 connects electric field programmable bi-stable element 14 (and, in particular, electrode 38a) to source region 18 of access transistor 12. The contact 34 and electrode 38a facilitate good electrical connection, and provide a low resistance between electrical path electric field programmable film 40 and, for example, source region 18 of access transistor 12.

It may be advantageous to employ materials and fabrication techniques that reduce and/or minimize the impact on the physical and electrical properties of electric field programmable film 40. In this regard, it may be advantageous to employ materials and techniques for fabricating electrode 38b (and electrode 38a) that do not (or do not detrimentally) impact the electrical and physical properties of electric field programmable film 40. For example, employing materials (for example, aluminum) that may be deposited and/or formed using temperatures below the thermal budget of electric field programmable film 40 will ensure the electrical and/or physical integrity of electric field programmable film 40 after deposition/application thereof.

Notably, each electrode 38 may be fabricated, deposited and/or formed from the same or different materials using the same or different fabrication techniques. In one embodiment, the thermal budget may allow electrode 38a to be fabricated, deposited and/or formed using a first technique and a first material requiring a greater temperature of fabrication, deposition and/or formation. After providing electric field programmable film 40, electrode 38b may be fabricated, deposited and/or formed using a second technique and/or a second material facilitating a relatively lower temperature of fabrication, deposition and/or formation. In this way, the electrical and/or physical integrity of electric field programmable film 40 after deposition/application of electrode 38b may be enhanced or maintained.

In another embodiment, electrodes 38a and 38b may each be comprised of materials that provide differing electrical characteristics. In this regard, electrode 38a may be fabricated from a material that has a work function that is different from the material of electrode 38b. In this way, electric field programmable bi-stable element 14 may include an asymmetrical response or behavior.

Further, it may be advantageous to provide electric field programmable bi-stable element 14 having a large area in order to enhance the current capabilities thereof. As such, electric field programmable bi-stable element 14 may be disposed above access transistor and extend over a significant portion of gate 16. In this way, the electrical characteristics of electric field programmable bi-stable element 14 are enhanced without significant (if any) impact on the overall dimensions of memory cell 10.

With reference to FIGURE 3B, in another embodiment, electric field programmable film 40 is disposed directly on source region 18 of access transistor 12. In this embodiment, source region 18 also functions or serves as an electrode of electric field programmable bi-stable element 14. As such, this embodiment provides a relatively more compact layout with fewer fabrication steps relative to the layout of FIGURE 3A. In addition, this embodiment may provide for a relatively large thickness of electric field programmable film 40, which may enhance the uniformity of electrical properties/characteristics of electric field programmable bistable element 14 between memory cells 10.

In yet another exemplary embodiment, with reference to FIGURE 3C, electrode 38a may be formed and/or patterned to directly contact source region 18 and extend over gate 16. In this embodiment, memory cells 10 within an array may include greater consistency in the electrical performance/response of electric field programmable bi-stable element 14 (with respect to the embodiments of FIGURES 3A and 3B) due to, for example, a relatively large surface area and relatively large thickness of electric field programmable film 40 which may be more easily fabricated and controlled to predetermined specifications.

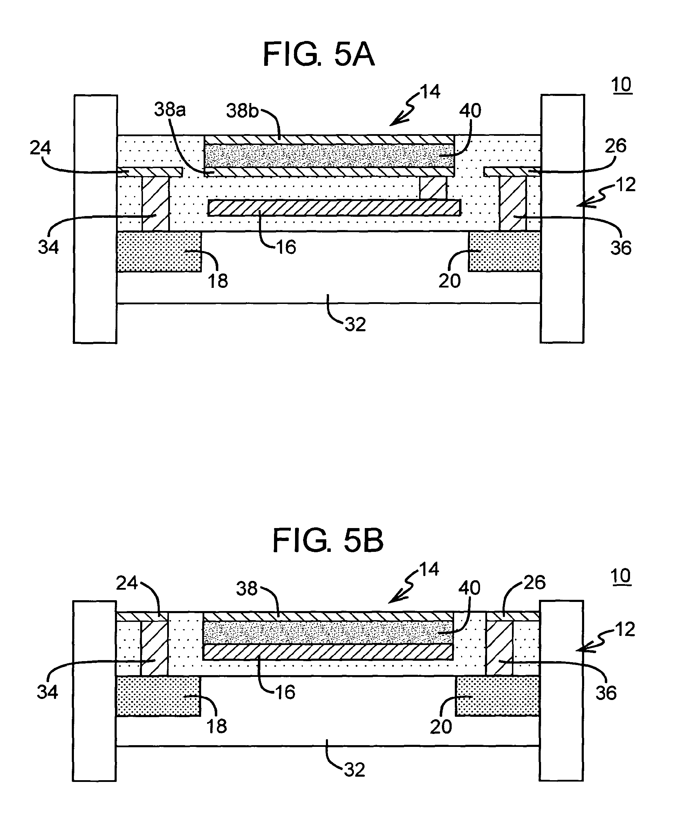

Notably, the layouts of FIGURES 3A-3C are equally applicable to memory cell 10 which is schematically represented in FIGURE 1C. In this regard, electric field programmable bi-stable element 14 is connected to drain region 20 of access transistor 12. For the sake of brevity, those discussions will not be repeated.The embodiment of memory cell 10 having electric field programmable bi-stable element 14 connected to gate 16 of access transistor 12 (schematically represented in FIGURE 1B), may also be fabricated using different materials, techniques and layouts. For example, with reference to FIGURE 5A, in one embodiment, memory cell 10 is fabricated in and/or on a bulk-type semiconductor wafer 32. The access transistor 12 may be fabricated from and using well known or conventional materials and techniques.

After fabricating (or concurrently therewith) access transistor 12, contacts 34 and 36, signal line 24, and sense/program signal line 26 may be fabricated from conductive materials (for example, aluminum or highly doped polysilicon) and formed and/or patterned using conventional deposition, lithographic and etching techniques. The electrode 38a of electric field programmable bi-stable element 14 may then be formed and/or patterned from a conductive-type material (for example, a heavily doped semiconductor (for example, polysilicon) or metal such as aluminum, chromium, gold, silver, molybdenum, platinum, palladium, tungsten, titanium, and/or copper). The electrode 38a may be deposited, formed and/or patterned using conventional or well-known fabrication techniques.

Thereafter, electric field programmable film 40 may be deposited on electrode 38a using any of the techniques described in Electric Field Programmable Films Patent Application. The electrode 38b may then be deposited. As with electrode 38a, electrode 38b may be a conductive-type material. The electrode 38b may be deposited, formed and/or patterned using conventional fabrication techniques.

As such, in this embodiment, electric field programmable bi-stable element 14 is disposed above access transistor 12 and includes electric field programmable film 40 disposed between electrodes 38a and 38b. An electrical contact connects electric field programmable bistable element 14 (and, in particular, electrode 38a) to gate 16 of access transistor 12.

As mentioned above, it may be advantageous to employ materials and fabrication techniques that reduce and/or minimize the impact on the physical and electrical properties of electric field programmable film 40 of those fabrication steps subsequent to deposition and formation of field programmable film 40. In this regard, employing materials (for example, aluminum) and techniques (deposition and/or formation techniques using below the thermal budget of electric field programmable film 40) for fabricating electrodes 38b will minimize the impact on the electrical and/or physical integrity of electric field programmable film 40 after deposition/application of electric field programmable film 40.

Moreover, as noted above, each electrode 38 may be fabricated, deposited and/or formed from the same or different materials using the same or different fabrication techniques. In one embodiment, the thermal budget may allow electrode 38a to be fabricated, deposited and/or formed using a first technique and a first material requiring a greater temperature of fabrication, deposition and/or formation. After providing electric field programmable film 40, electrode 38b may be fabricated, deposited and/or formed using a second technique and/or a second material facilitating a relatively lower temperature of fabrication, deposition and/or formation. In this way, the electrical and/or physical integrity of electric field programmable film 40 after deposition/application of electrode 38b may be enhanced or maintained.

With reference to FIGURE 5B, in another embodiment, electric field programmable film 40 is disposed directly on gate 16 of access transistor 12. In this embodiment, gate 16 also functions as an electrode of electric field programmable bi-stable element 14.

Briefly, after fabrication of access transistor 12, contacts 34 and 36 may be formed. Thereafter, electric field programmable film 40 may be deposited, formed and/or patterned on gate 16 using, for example, any of the techniques described in the references cited above.

The signal line 24 and sense/program signal line 26 may be deposited, formed and/or patterned from conductive materials (for example, aluminum or highly doped polysilicon) using conventional deposition, lithographic and etching techniques. Thereafter (or concurrently therewith), electrode 38 may be deposited. It may be advantageous to employ materials and techniques that maintain the physical and electrical integrity of electric field programmable film 40 during the deposition, formation and/or patterning process. As mentioned above, electrode 38 may be a conductive-type material (for example, a heavily doped semiconductor (for example, polysilicon) or metal (for example, aluminum, chromium, gold, silver, molybdenum, platinum, palladium, tungsten, titanium, and/or copper).

Notably, the embodiment of FIGURE 5B provides a more compact layout of memory cell 10, relative to memory cell 10 of FIGURE 5A, while employing fewer fabrication steps. Moreover, the embodiment of FIGURE 5B may facilitate implementation of a relatively large thickness of electric field programmable film 40 which may enhance the consistency and/or uniformity of the bi-stable electrical properties of electric field programmable film 40 of memory cells 10 of a memory array.

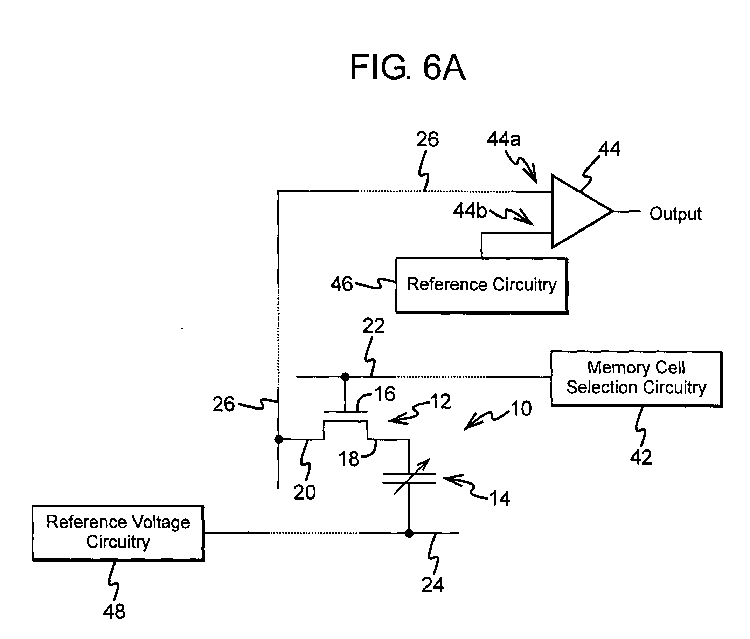

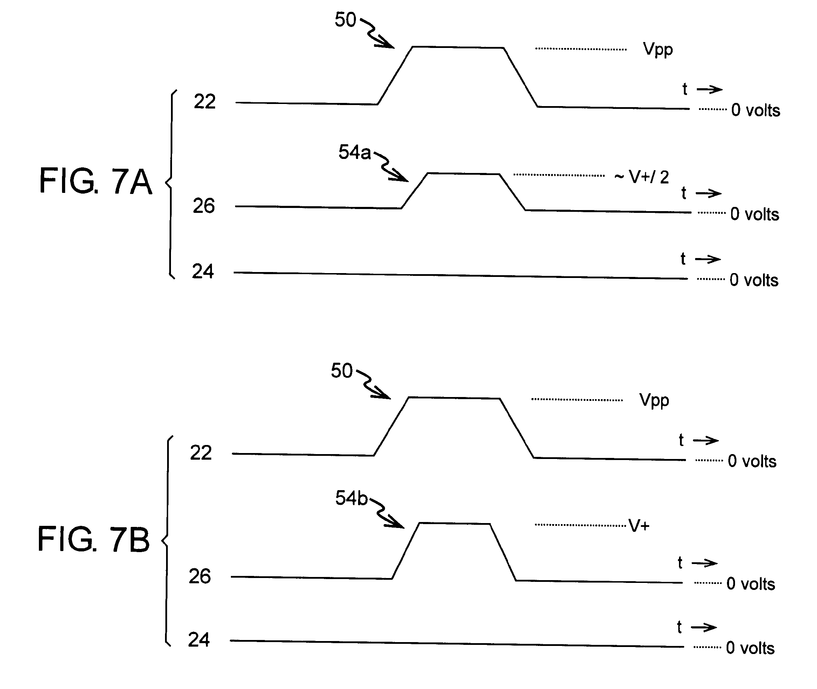

The read, write and/or erase operations may be performed by controlling the amplitude and timing of the voltages applied to access transistor 12 and electric field programmable bi-stable element 14. For example, with reference to FIGURES 6A and 7A, the data state of memory cell 10 may be read when signal line 22 is selected, via memory cell selection circuitry 42, thereby enabling or first turning "on" access transistor 12 and electrically coupling electric field programmable bi-stable element 14 to sense/program signal line 26 (through access transistor 12). (See, 50 in FIGURE 7A). Notably, where memory cell 10 is one of many or a plurality of memory cells in a memory array, memory cell selection circuitry 42 may be a conventional word line decoder/driver. Indeed, any word line decoder/driver, whether now known or later developed, is intended to be within the scope of the present invention.

A sense amplifier 44 (for example, a conventional cross-coupled sense amplifier) is connected to sense/program signal line 26 to detect the data state of memory cell 10. In this regard, in one embodiment, sense amplifier 44 detects the data state of memory cell 10 by comparing the voltages applied to inputs 44a and 44b. The voltage applied to input 44a of sense amplifier 44 will depend, to a large extent, on the resistive characteristics of electric field programmable bi-stable element 14 (which were previously programmed in a manner described below). The voltage applied to input 44b will depend on the reference voltage that is provided or output by reference circuitry 46.

In one embodiment, reference circuitry 46 may be a voltage reference or a current source. Where reference circuitry 46 is a current source, the output current of the current source should provide an appropriate voltage or current at input 44b of sense amplifier 44 to permit sense amplifier 44 to detect the data state of electric field programmable bi-stable element 14. That is, in one embodiment, the amount of current output would be between the amount of current equivalent to a high data state and a low data state of electric field programmable bistable element 14. In a preferred embodiment, the amount of current is substantially equal to one-half of the sum of the amount of current equivalent to a high data state and a low data state of electric field programmable bi-stable element 14.

In another embodiment, reference circuitry 46 includes at least two reference memory cells (not illustrated), each including a reference access transistor and a reference electric field programmable bi-stable element. In this embodiment, one of the reference memory cells is programmed to a high data state and one of the reference memory cells is programmed to a low data state. The reference circuitry 46, in one embodiment, provides a voltage at input 44b that is substantially equal to one-half of the sum of the two reference memory cells. The memory cell 10 is read by coupling electric field programmable bi-stable element 14 to input 44a and the reference voltage generated by reference circuitry 46 to input 44b.

It may be advantageous to employ the reference memory cells configuration described above in order to track and/or address variations in the memory cell characteristics due to changes in operating conditions (for example, temperature variations and/or power variations), or in fabrication conditions (for example, film thickness variations across the wafer).

Thus, the circuitry employed to read the data state of memory cell 10 (for example, sense amplifier 44 and reference circuitry 46) may sense the data state stored in memory cell 10 using voltage or current sensing techniques. Such circuitry and configurations thereof are well known in the art. (See, for example, Published U.S. Patent Application 2004/0165462 and U.S. Patent 6,785,163). Indeed, any circuitry or architecture to sense, sample, detect or determine the data state of memory cell 10, whether now known or later developed, is intended to be within the scope of the present invention.

The reference voltage circuitry 48, in one embodiment, may be circuitry that provides a stable reference voltage (for example, a ground potential or zero volts). In other embodiments, reference voltage circuitry may provide certain control signals having well defined voltage levels and timing characteristics.

Notably, pass gates and/or column switch circuitry (not illustrated) may be employed to selectively connect access transistor 12 (electric field programmable bi-stable element 14) to sense amplifier 44 to facilitate and/or implement the read operation of the data state of memory cell 10.

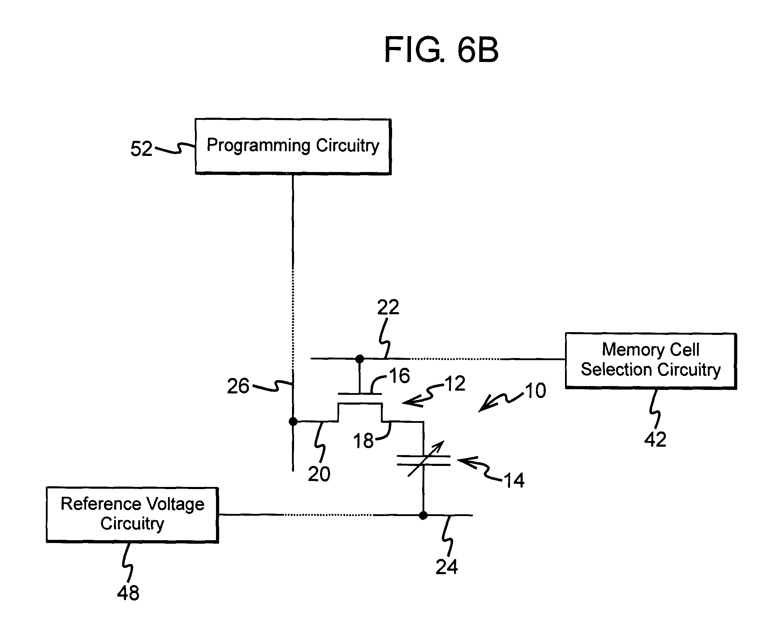

With reference to FIGURES 6B and 7B, the data state of memory cell 10 may be programmed by coupling electric field programmable bi-stable element 14 to sense/program signal line 26 and applying an appropriate voltage across electric field programmable film of electric field programmable bi-stable element 14. In this regard, memory cell selection circuitry 42 turns on access transistor 12 (i.e., forward biases transistor 12) by applying a sufficiently high voltage (in the case of an N-channel device) on signal line 22 (See, 50 in FIGURE 7B). In this way, electric field programmable bi-stable element 14 is electrically coupled to sense/program signal line 26.

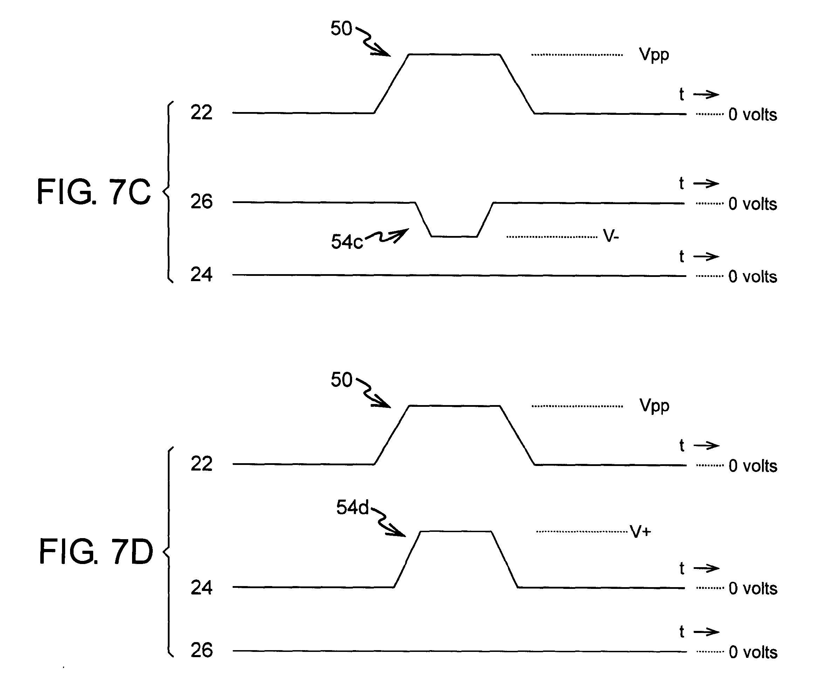

While access transistor 12 is "on", programming circuitry 52 applies the appropriate voltage to store either a logic high or logic low. In this regard, with reference to FIGURE 2, providing or applying a voltage difference of approximately 4.5 volts across electric field programmable film 40 stores a logic high in electric field programmable bi-stable element 14. (See, FIGURE 7B). In contrast, providing or applying a voltage difference of approximately 2 volts across the electric field programmable film erases the logic high, thereby storing a logic low in electric field programmable bi-stable element 14. (See, FIGURES 7C and/or 7D, respectively). A voltage difference of 2 volts may be provided by controlling the voltages applied to control signal lines 24 and 26.

Notably, pass gates and/or column switch circuitry (not illustrated) may be employed to selectively connect access transistor 12 to programming circuitry 52 to facilitate and/or implement the programming operation of memory cell 10. Moreover, switches (for example, transistors or the like) may be employed to connect reference voltage circuitry to signal line 24 of a selected/addressed memory cell 10.

There are many different techniques (and circuitry therefor) to implement the erase and write operations. All such techniques and circuitry therefor, whether now known or later developed, are intended to fall within the scope of the present invention. For example, programming circuitry 52 may be a switch (implemented via, for example, a transistor) having one "terminal" coupled to ground or reference. In this way, reference voltage circuitry 48 may program (erase or write) by applying a suitable voltage to control signal line 24.

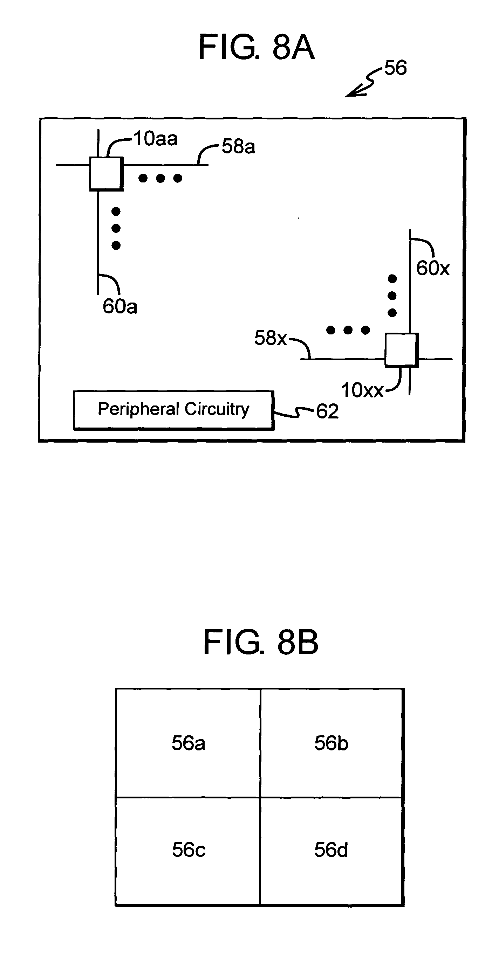

The memory cell 10 is often employed or implemented in memory array 56 having a plurality of memory cells 10. With reference to FIGURE 8A, in one embodiment, memory cells 10aa-xx are located at cross points of matrix of rows 58a-x and columns 60a-x. The peripheral circuitry 62 (for example, clock alignment circuitry, address decoding, word line drivers, row drivers, and output drivers, sense amplifiers and reference voltage circuitry) may be included to provide control signals to the memory cells 10aa-xx to implement and/or facilitate such operations as reading from and writing into the memory cells 10aa-xx. Notably, with reference to FIGURE 8B, a memory device may include a plurality of memory arrays (or sub-arrays), for example, arrays 56a-d. Indeed, memory cells 10aa-xx of memory array 56 may be arranged or configured in any architecture or layout, including, for example, array, sub-array and addressing architecture or layout, whether now known or later developed.

In another aspect, the present invention includes a plurality of memory cells, each having a unique, different and/or distinct electric field programmable bi-stable element and a common access transistor. In this aspect of the present invention, the electric field programmable bi-stable elements of the memory cells "share" an access transistor. That is, the plurality of memory cells includes a common access transistor and unique, different and/or distinct electric field programmable bi-stable elements.

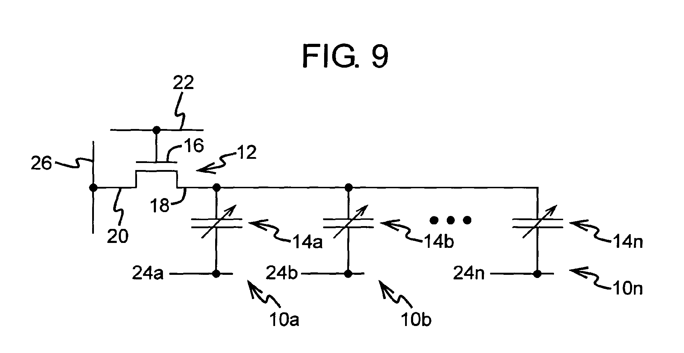

With reference to FIGURE 9, in one embodiment, one access transistor 12 is coupled to a plurality of electric field programmable bi-stable elements 14a-n. The electric field programmable bi-stable elements 14a-n each store data that is individually addressable. In this regard, a data state may be written into and read from electric field programmable bi-stable elements 14a-n individually (serially or in parallel) by controlling the voltage levels of signal lines 22, 24a-n and 26.

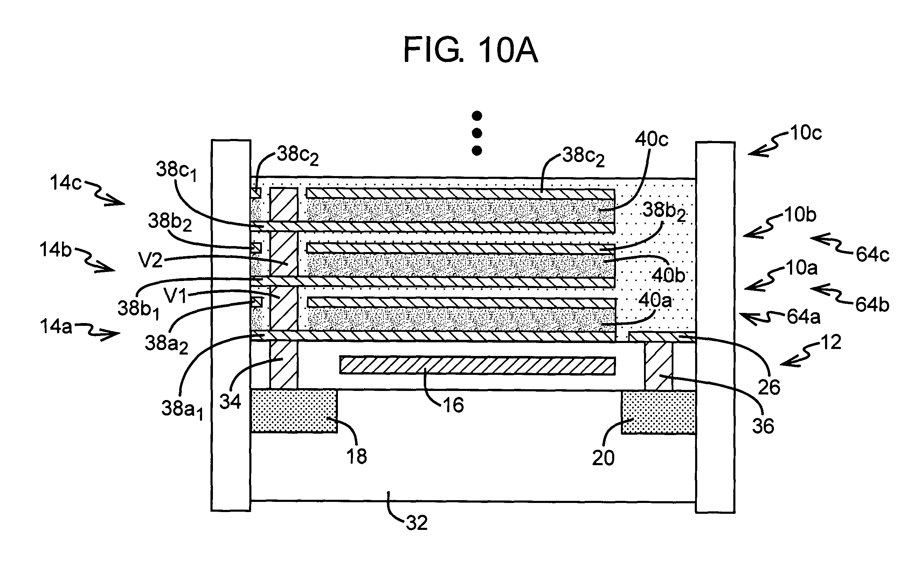

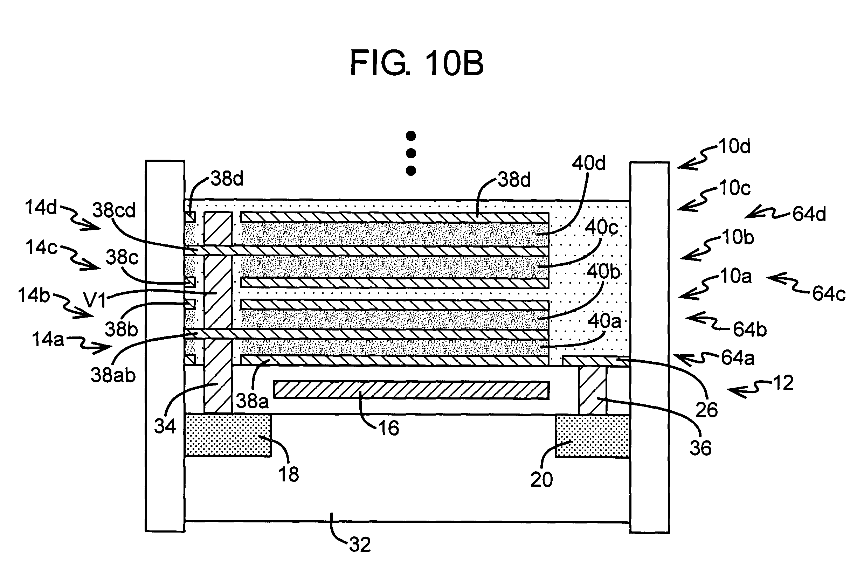

The plurality of memory cells 10a-n of FIGURE 9 may be fabricated using a number of techniques. Moreover, memory cells 10a-n may include a number of different configurations and layouts. For example, with reference to FIGURES 10A and 10B, in at least one embodiment, electric field programmable bi-stable elements 14a-c may be disposed above access transistor 12 in a stacked arrangement. In this way, the density of a memory device including this aspect of the invention may be enhanced.

In particular, with continued reference to FIGURE 10A, memory cells 10a-c include electric field programmable bi-stable elements 14a-c, respectively, and shared or common access transistor 12. The electric field programmable bi-stable element 14a includes electric field programmable film 40a disposed between electrodes 38a₁ and 38a₂. The electrode 38a₁ is electrically connected to source 18 of access transistor 12 via contact 34. The electrode 38a₂ is connected to signal line 24a (not illustrated). Indeed, in one embodiment, electrode 38a₂ is signal line 24a.

The electric field programmable bi-stable element 14b includes electric field programmable film 40b disposed between electrodes 38b₁ and 38b₂. A conductive via V1 electrically connects electrode 38b₁ to source 18 of access transistor 12 (through electrode 38a₁ and contact 34). The electrode 38b₂ is connected to signal line 24b (not illustrated).

Similarly, electric field programmable bi-stable element 14c includes electric field programmable film 40c disposed between electrodes 38c₁ and 38c₂. A conductive via electrically connects electrode 38c₁ to source 18 of access transistor 12 (through electrodes 38a₁ and 38b₁, conductive via V1 and contact 34). The electrode 38c₂ is connected to signal line 24c (not illustrated).

Notably, in one embodiment, electrodes 38a₁, 38b₂ and 38c₂ may be signal lines 24a-c, respectively.

With reference to FIGURE 10B, another exemplary layout of memory cells 10 of this aspect of the present invention includes a more dense configuration than that illustrated in FIGURE 10A. In this regard, electric field programmable bi-stable elements 14a and 14b "share" electrode 38ab. Similarly, electric field programmable bi-stable elements 14c and 14d "share" electrode 38cd. In this way, a more compact and dense memory array may be provided using fewer manufacturing processes and materials. Notably, all layouts of memory cells 10 of this aspect of the invention, whether now known or later developed, are intended to be within the scope of the present invention.

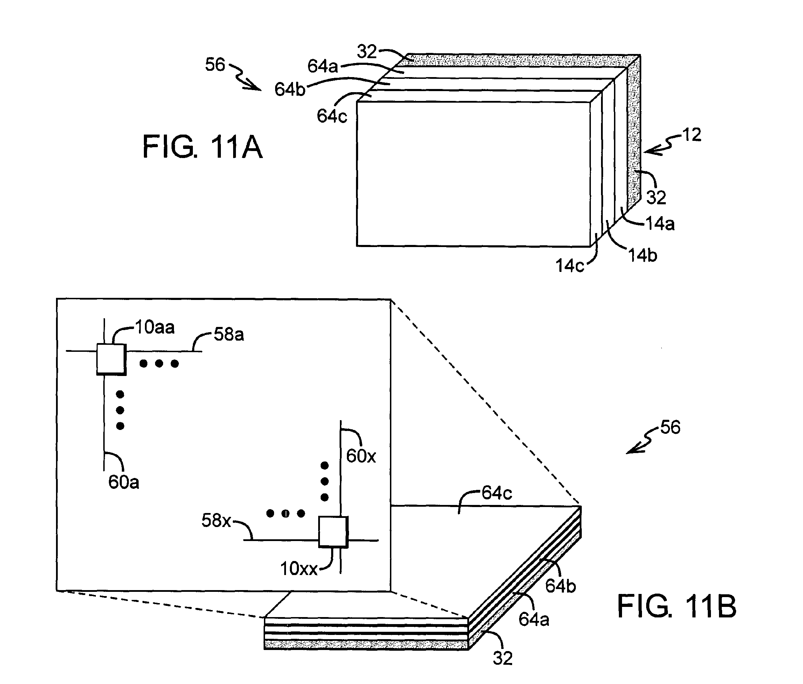

Thus, with reference to FIGURES 10A, 11A and 11B, memory cells 10a-c of this aspect of the invention include a stacked layout configuration. That is, access transistor 12 is disposed in substrate 32 and electric field programmable bi-stable elements 14a-c are disposed in layers 64a-c, respectively, of memory array 56. Each layer 64a-c of memory array 56 effectively includes a plurality of memory cells 10aa-xx, having an access transistor 12 disposed in or on substrate 32 and electric field programmable bi-stable element 14 in the layer 64. (See, FIGURE 11B).

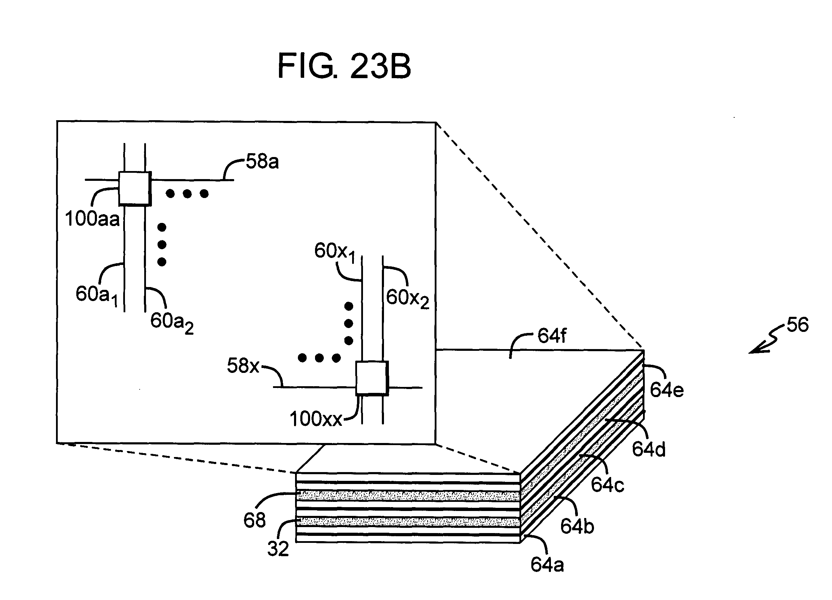

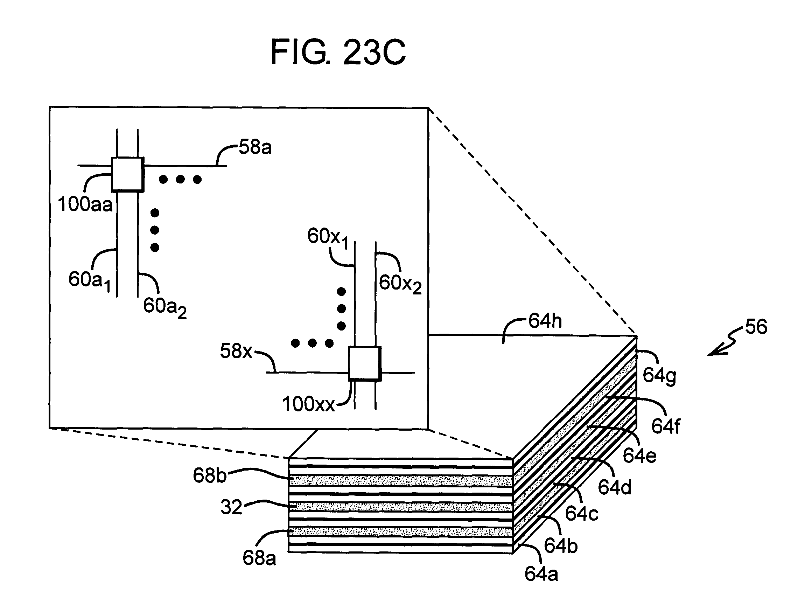

Notably, as mentioned above, transistors 12 may be fabricated, formed, disposed and/or located in a different (for example, "higher") plane or layer relative to a monocrystalline substrate. In this regard, transistors 12 may be fabricated from or in polysilicon, amorphous silicon or other non-crystalline material. Under this circumstance, a 3-dimensional array of memory may be fabricated wherein one or more layers (in addition to or in lieu of the substrate) may include access transistors (and/or peripheral circuitry). (See, for example, layers 68 in FIGURES 23A-23C). As such, electric field programmable bi-stable elements 14 may be formed, disposed and/or located in layers or planes that are above and/or below such transistors. Moreover, transistor 12 may be associated with electric field programmable bi-stable elements 14 that are formed, disposed and/or located in layers or planes that are above and/or below the layer and/or plane in which that transistor 12 is are formed, disposed and/or located. (See, for example, FIGURES 23B and 23C)

The memory cells 10 of 3-dimensional memory array 56 of FIGURES 11A and 11B may be arranged or configured in any architecture or layout whether now known or later developed. For example, the orientation of subarrays and/or subarray sections may be 3-dimensional or 2-dimensional (in either a vertical or horizontal plane). In this way, the orientation of subarrays and/or subarray sections may be selected to enhance, for example, yield, addressing, reading, writing and/or erase operations.

Moreover, the orientation of subarrays and/or subarray sections may be selected to minimize peripheral circuitry, for example, where the subarrays may be defined in vertical planes perpendicular to the surface of substrate 32, the peripheral circuitry may be disposed and consume a majority of the area of substrate 32.

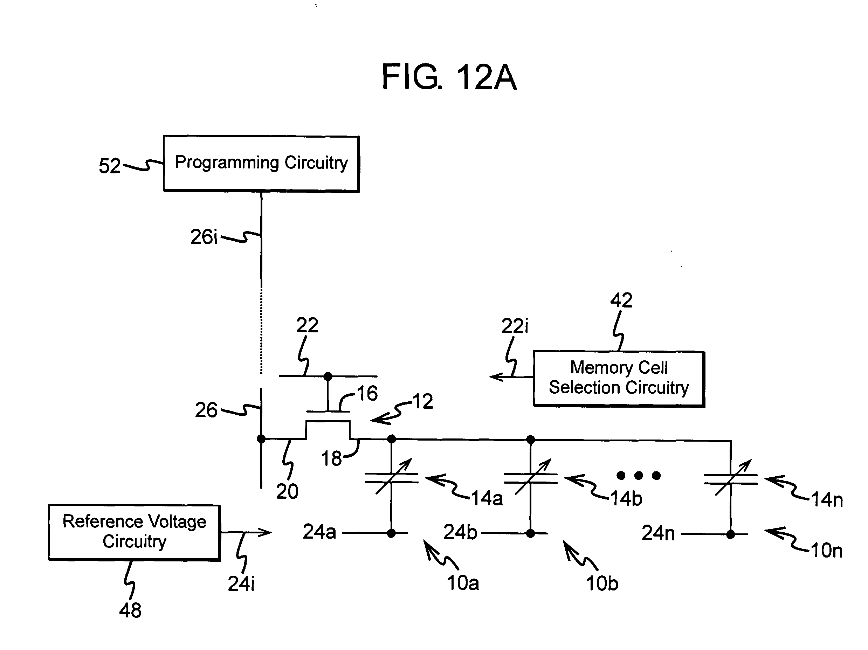

The write or programming operation for memory cells 10a-n are performed by applying control voltages to access transistor 12 and signal lines 24a-n, to thereby enable or turn on access transistor 12, and to store the appropriate data state in electric field programmable bistable element 14. With reference to FIGURE 12A, the data state of memory cell 10a, for example, may be programmed by coupling electric field programmable bi-stable element 14a to sense/program signal line 26 and applying an appropriate voltage across electric field programmable film of electric field programmable bi-stable element 14a via programming circuitry 52 and reference voltage circuitry 48. In this regard, memory cell selection circuitry 42 enables or turns on access transistor 12 by applying an appropriate positive voltage on signal line 22 (for N-channel transistors). In this way, electric field programmable bi-stable element 14a is electrically coupled to sense/program signal line 26.

Thereafter, and while access transistor 12 is "on", programming circuitry 52 applies an appropriate voltage (in relation to the voltage applied on signal line 24 by reference voltage circuitry 48) to store either a logic high or logic low in electric field programmable bi-stable element 14a. For example, in one embodiment (see, for example, the IV characteristics of an exemplary film in FIGURE 2), providing or applying a voltage difference of approximately 4.5 volts across electric field programmable film of electric field programmable bi-stable element 14a stores a logic high. In contrast, providing or applying a voltage difference of approximately 2 volts across the electric field programmable film of electric field programmable bi-stable element 14a erases the logic high, thereby storing a logic low. A voltage difference of 2 volts may be provided by applying suitable voltages to control signal lines 24 and 26. (See, for example, FIGURES 7C and 7D).

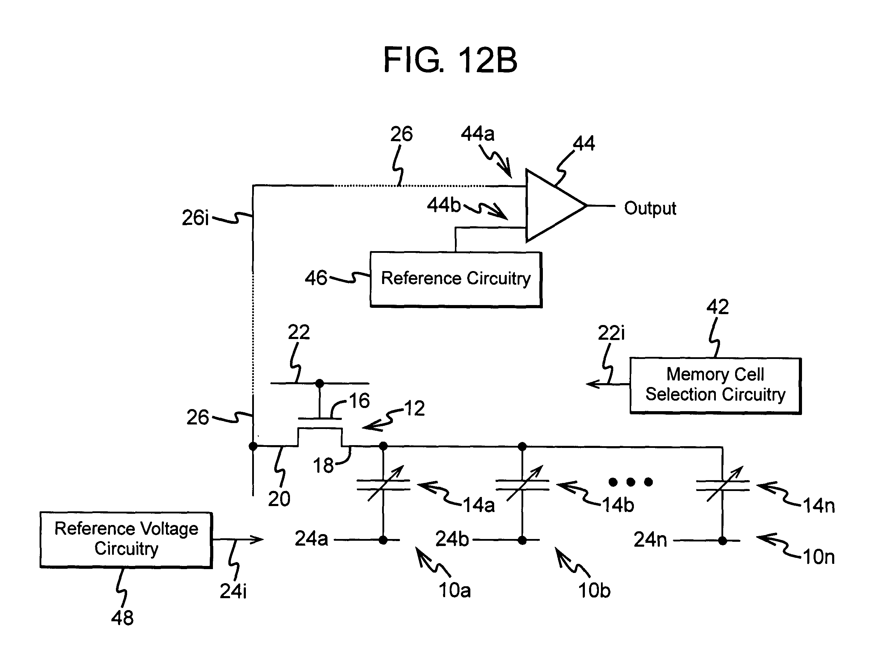

With reference to FIGURE 12B, in one embodiment, the data state of memory cell 10a is read by enabling or first turning access transistor 12 "on" (by applying a control signal on signal line 22 via memory cell selection circuitry 42). This electrically couples electric field programmable bi-stable element 14a (through access transistor 12) to sense/program signal line 26. Notably, a reference voltage (for example, ground) is applied on signal line 24a by reference voltage circuitry 48.

As mentioned above, sense amplifier 44 (for example, a conventional cross-coupled sense amplifier) is connected to sense/program signal line 26 to detect the data state of memory cell 10. For the sake of brevity, those discussions will not be repeated, but will be summarized. The sense amplifier 44 may be a voltage or current based amplifier. The sense amplifier 44 detects the data state of memory cell 10a by comparing the voltages or currents applied to inputs 44a and 44b. For example, the voltage applied to input 44a of sense amplifier 44 depends, to a large extent, on the resistive characteristics of electric field programmable bi-stable element 14a. The voltage applied to input 44b will depend on the reference voltage that is output of reference circuitry 46.

Notably, pass gates and/or column switch circuitry (not illustrated) may be employed to selectively connect access transistor 12 (electric field programmable bi-stable element 14a) to sense amplifier 44 to facilitate and/or implement the read operation of the data state of memory cell 10a.

As mentioned above, there are many different techniques (and circuitry to implement such techniques) for performing the read, write and/or erase operations of memory cells 10a-n of this aspect of the present invention. All such techniques, and circuitry therefor, whether now known or later developed, are intended to fall within the scope of the present invention.

Moreover, as mentioned above, memory cells 10a-n may include a number of different configurations and layouts. Indeed, electric field programmable bi-stable elements 14a-c may include different electrical properties, for example, different "on" and/or "off" resistances, write and/or erase voltages. In this regard, in one embodiment, the size of each of electric field programmable bi-stable elements 14a-c may be different in order to provide a different response to certain control signals. In this way, the data state of electric field programmable bi-stable elements 14a-c may be read more quickly (relative to consecutive read/write/erase embodiments) and/or simultaneously because, for example, the response of the memory cells 10 including electric field programmable bi-stable elements 14a-c will differ. Thus, with reference to FIGURE 12A and 12B, control signal lines 24a-n may be used to write a data state into memory cells 10a-n.

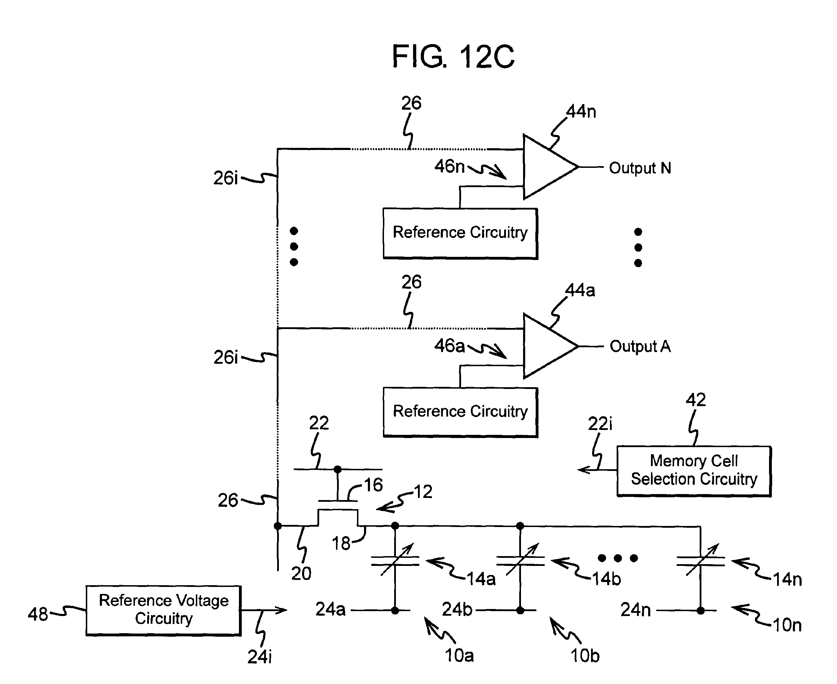

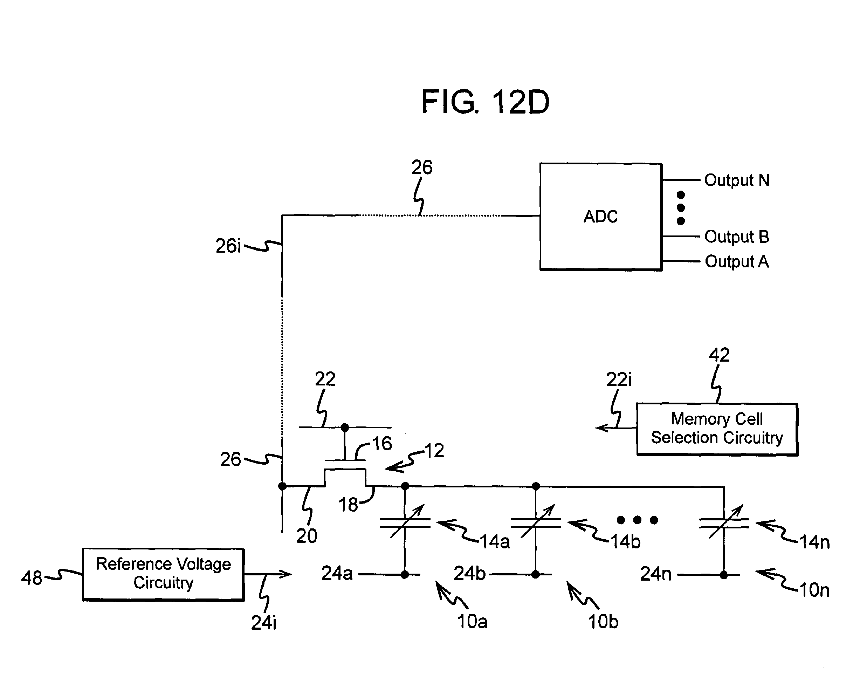

With reference to FIGURES 12C and 12D, when reading the data state of memory cells 10a-n, control signal lines 24a-n may be placed at the same or similar voltage levels (for example, shorted together), transistor 12 turned "on" and the resulting current or voltage may be read out by means of a number of sense amplifiers 44a-n with different reference inputs 46a-n, and the result placed on data output lines (Output A-N) as in FIGURE 12C, or the resulting current or voltage may be read out by analog-to-digital converter (ADC), and the result placed on data output lines (Output A-N), as shown in FIGURE 12D. These or other methods may discern between the multiple voltage (or current) signals or levels output by memory cells 10a-n. As such, the data state stored in more than one memory cell 10 may be read, simultaneously or consecutively.

The memory cells 10a-n of this aspect of the invention may be fabricated using the same techniques and materials mentioned above with respect to the memory cell 10 described and illustrated in, for example, FIGURES 1A-C, 2, 3A-C, 4, 5A and 5B. For the sake of brevity, those discussions will not be repeated.

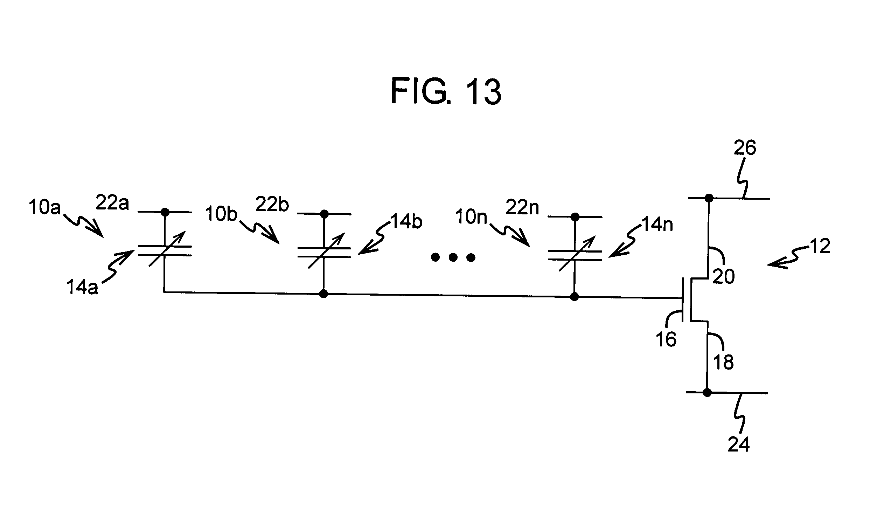

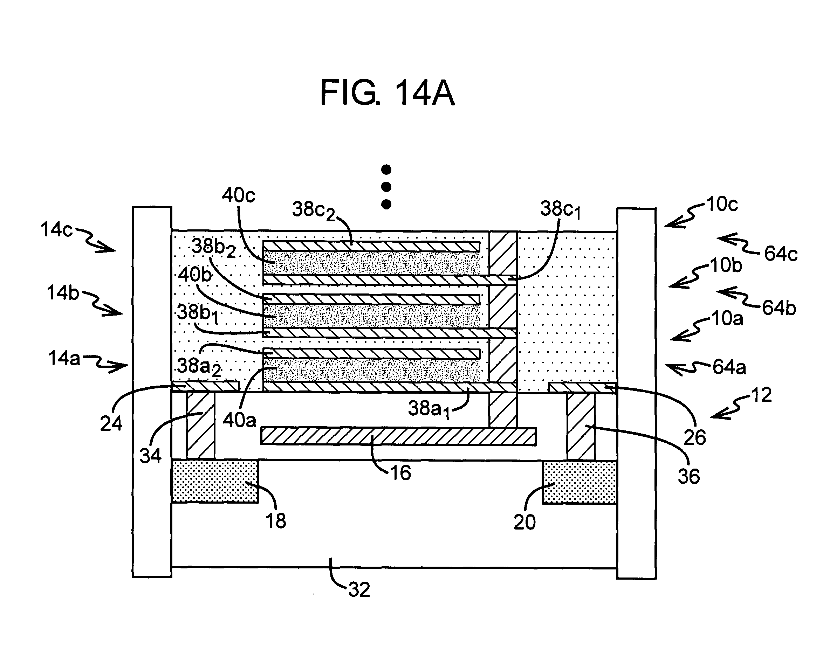

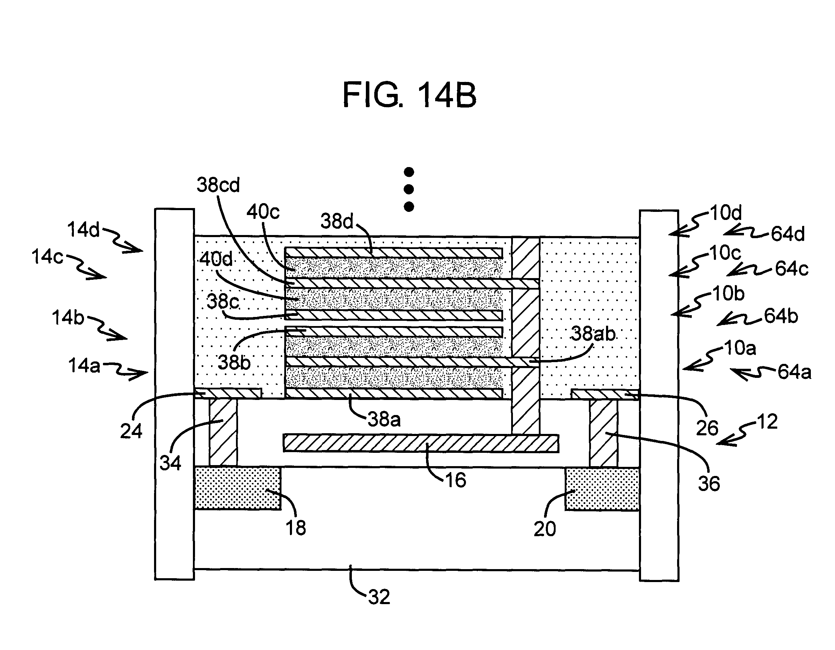

Moreover, memory cells 10a-n of this aspect of the present invention may be arranged in any of the configuration of the memory cells 10 of FIGURES 1A-1C (as described and illustrated above). For example, with reference to FIGURE 13, electric field programmable bi-stable elements 14a-n may be connected to gate 16. Notably, transistor 12 and electric field programmable bi-stable elements 14a-n of this embodiment, in combination, form a logic OR or a logic NOR configuration. In this embodiment, memory cells 10a-n may also employ a stacked layout configuration wherein access transistor 12 is disposed in or on substrate 32 and electric field programmable bi-stable elements 14a-n are disposed in layers of electric field programmable film 40 which are disposed above access transistor 12 (and substrate 32). (See, FIGURES 14A and 14B). As such, each layer 64a-n of electric field programmable film 40 (in conjunction with access transistor 12) "effectively" includes a plurality of memory cells 10, having an access transistor 12 disposed in or on substrate 32 and electric field programmable bistable element 14 in a layer 64. (See, for example, FIGURES 11B, 14A and 14B).

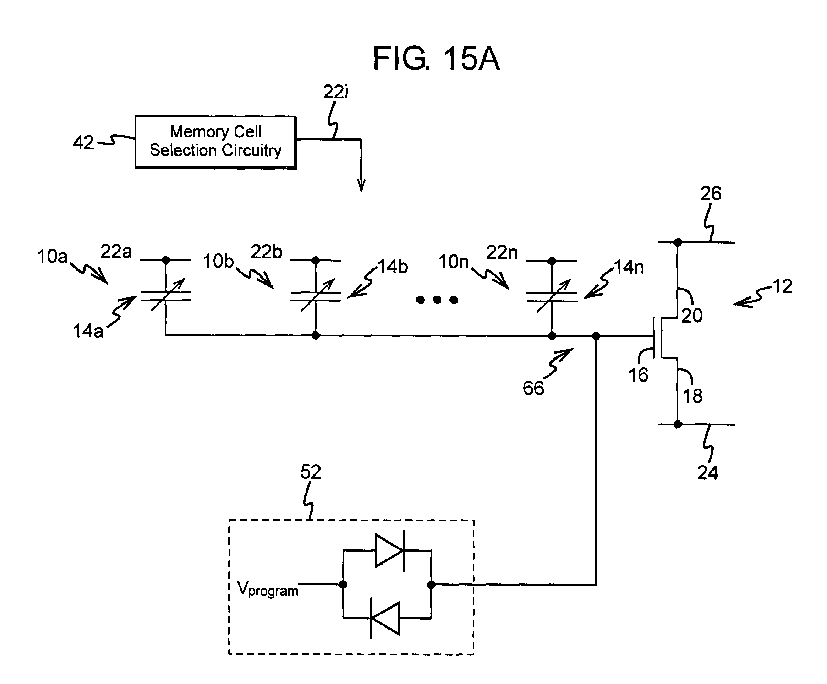

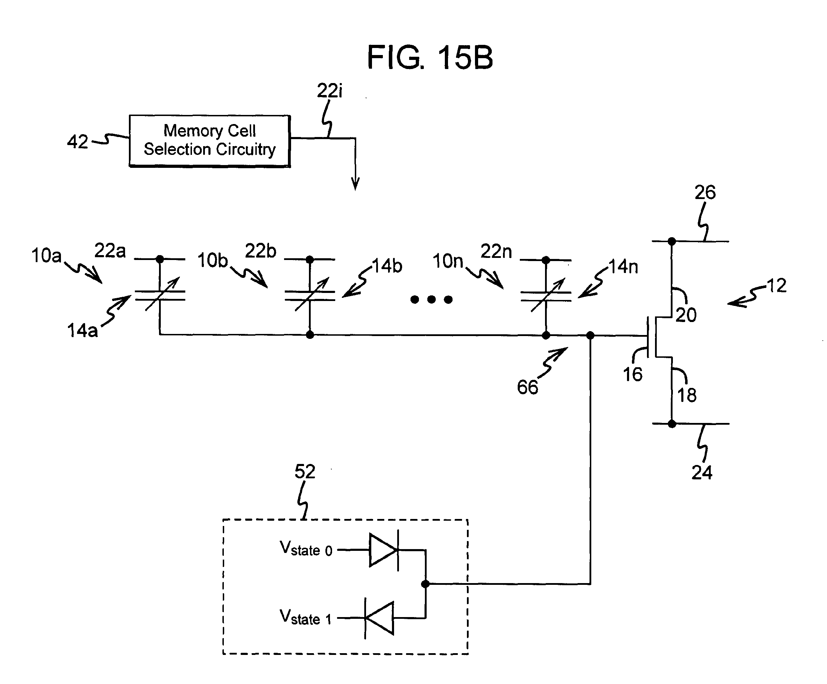

The memory cells 10a-n of FIGURE 13 may be programmed by selectively controlling the voltage applied across electric field programmable film 40 of electric field programmable bi-stable element 14. In this regard, memory cell selection circuitry 42 applies control signals on signal line 22a-n to facilitate programming (and reading) the data state of (or information stored in) field programmable bi-stable elements 14a-n. In particular, with reference to FIGURES 15A and 15B, memory cell(s) 10 is/are selectively programmed by applying a first control signal (having a predetermined voltage level) to one or more signal lines 22a-n. A second control signal (having a predetermined voltage level) is applied at node 66 by programming circuitry 52. With reference to FIGURE 2, in one embodiment, memory cell selection circuitry 42 and programming circuitry 52 apply appropriate voltages to store either a logic high or logic low in one or more selected memory cells. In this regard, providing or applying a voltage difference of approximately 4.5 volts across electric field programmable film 40 stores a logic high in electric field programmable bi-stable element 14. In contrast, providing or applying a voltage difference of approximately 2 volts across electric field programmable film erases the logic high, thereby storing a logic low in electric field programmable bi-stable element 14. A voltage difference of 2 volts may be provided by applying suitable voltages to control signal lines 24 and 26. Notably, memory cells 10a-n may be programmed serially or in parallel.

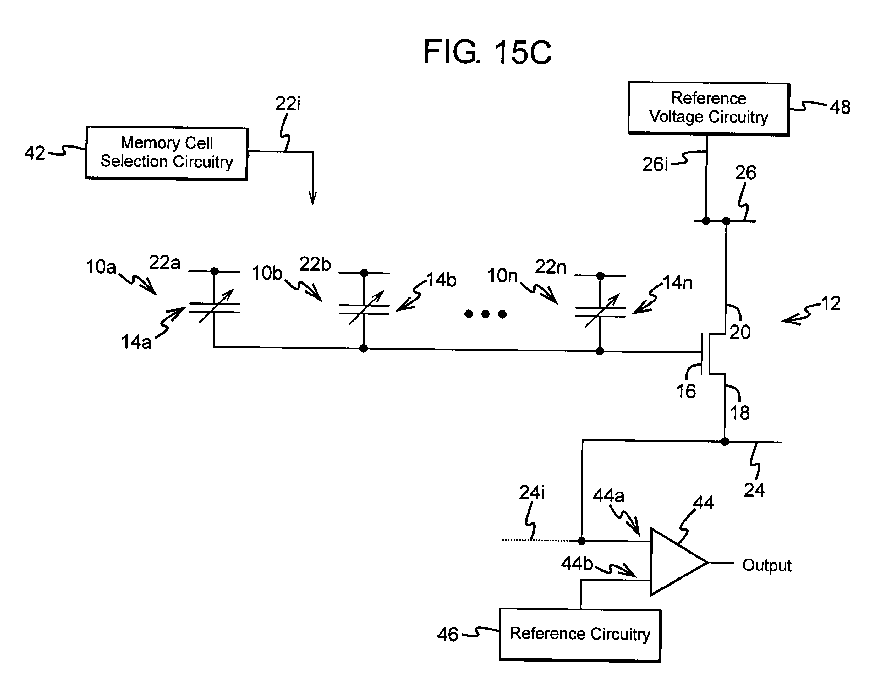

The data state stored in memory cells 10a-n of FIGURE 13 may be read by selecting or enabling a memory cell 10a-n by a control signal applied by memory cell selection circuitry 42 to signal line 22 and sensing a current or voltage response of access transistor 12. In particular, with reference to FIGURE 15C, in one embodiment, the data state of memory cell 10a, for example, may be read by applying a read voltage on signal line 22a via memory cell selection circuitry 42, which, in turn, applies a voltage on gate 16 of access transistor 12 which is representative of the data state stored in electric field programmable bi-stable element 14a (i.e., due to the resistive characteristics of the electric field programmable film as previously programmed). The voltage on gate 16 of access transistor 12 determines the operating characteristics of access transistor 12 which are applied to (via node 44a) and sensed by sense amplifier 44.

The sense amplifier 44 (for example, a conventional cross-coupled sense amplifier) detects the data state of memory cell 10. In this regard, in one embodiment, sense amplifier 44 detects the data state of memory cell 10 by comparing the voltages applied to inputs 44a and 44b. The voltage applied to input 44a of sense amplifier 44 will depend, to at least a large extent, on the resistive characteristics of electric field programmable bi-stable element 14a and its impact on the operating characteristics of access transistor 12. The voltage applied to input 44b will depend on the reference voltage that is output of reference circuitry 46.

As mentioned above, reference circuitry 46 may be a voltage reference or a current source and reference voltage circuitry 48, in one embodiment, may be circuitry that provides a stable reference voltage (for example, a stable and highly controllable positive voltage in order to turn on or enable access transistor 12, which, in this embodiment, is an N-channel type transistor). For the sake of brevity, those discussions will not be repeated here.

Notably, the circuitry employed to read the data state of memory cells 10a-n (for example, sense amplifier 44 and reference circuitry 46) may employ well known circuitry, configurations and techniques. Any circuitry, architecture or technique to sense, sample, detect or determine the data state of memory cell 10a-n, whether now known or later developed, is intended to be within the scope of the present invention.

Notably, pass gates and/or column switch circuitry (not illustrated) may be employed to selectively connect access transistor 12 (electric field programmable bi-stable element 14a) to sense amplifier 44 to facilitate and/or implement the read operation of the data state of memory cell 10.

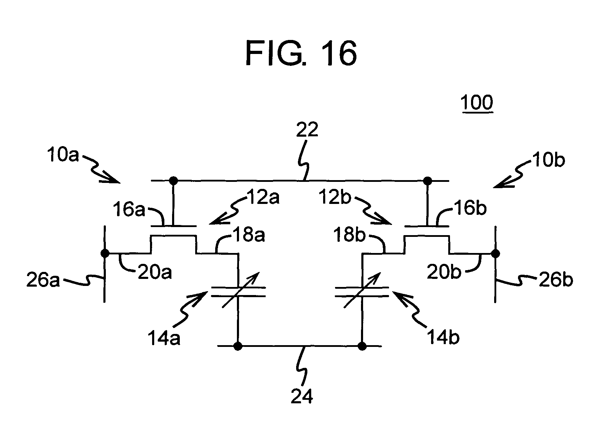

In another aspect, the present invention includes a differential memory cell having a plurality of memory cells configured to store complementary data states. In this regard, with reference to FIGURE 16, differential memory cell 100 includes first memory cell 10a and second memory cell 10b wherein first memory cell 10a maintains a complementary state relative to second memory cell 10b. The memory cells 10a and 10b each include access transistor 12 and an electric field programmable bi-stable element 14. Thus, when programmed, one of the memory cells (for example, 10a) stores a logic low and the memory cell (in this example, 10b) stores a logic high.

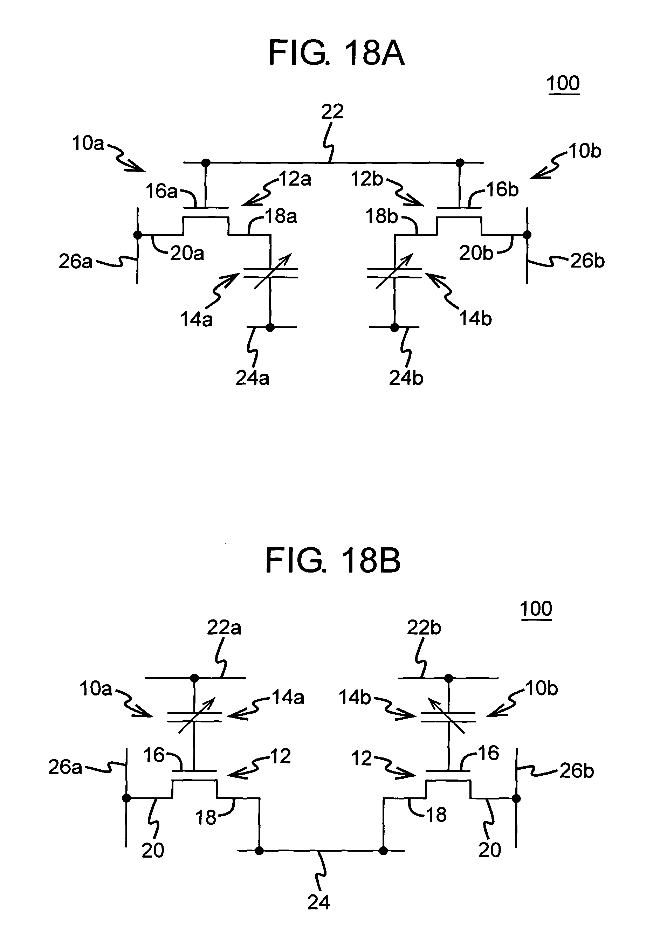

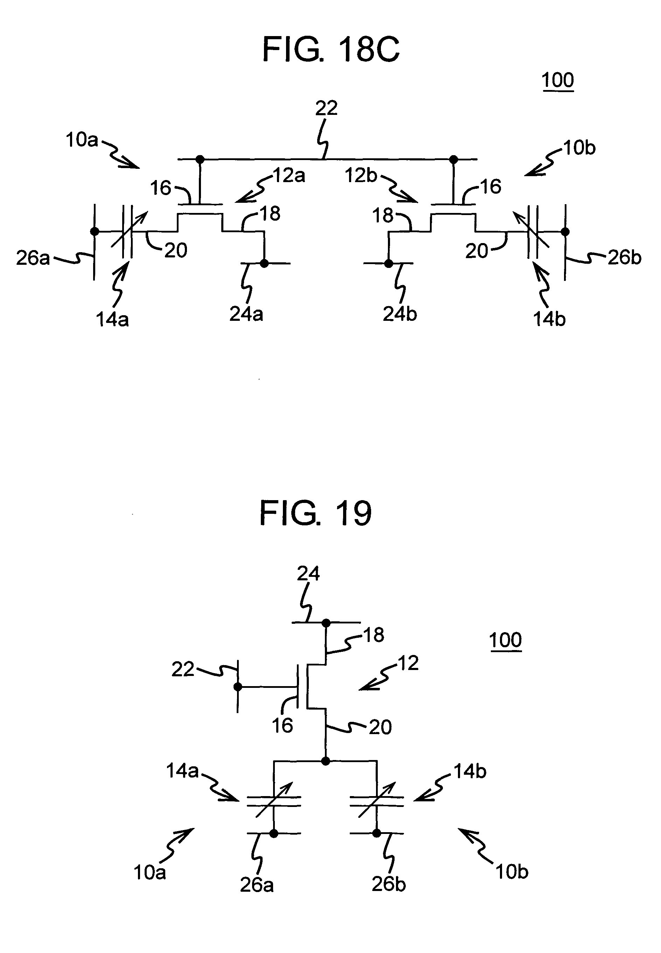

The memory cells 10a and 10b of differential memory cell 100 may be manufactured, configured and/or controlled as described and illustrated with respect to any of the embodiments of any of the aspects of the present inventions described herein. Moreover, memory cells 10a and 10b may include a layout as described and illustrated with respect to any of the embodiments of any of the aspects of the present inventions described herein. (See, for example, FIGURES 18A-18C). For the sake of brevity, those details, discussions and illustrations will not be repeated.

Briefly, the data state of the two-transistor differential memory cell 100 may be read and/or determined by sampling, sensing measuring and/or detecting the logic states stored in each cell 10 of differential memory cell 100. That is, memory cells 100 may be read by sampling, sensing, measuring and/or detecting the difference in the resistive values stored or exhibited in electric field programmable bi-stable element 14a and 14b. In a first logic state of memory cell 100, memory cell 10a stores a logic low and memory cell 10b stores a logic high. In contrast, in a second logic state of differential memory cell 100, memory cell 10a stores a logic high and memory cell 10b stores a logic low. The difference in resistive values may be sampled, sensed, measured and/or detected using current or voltage based techniques.

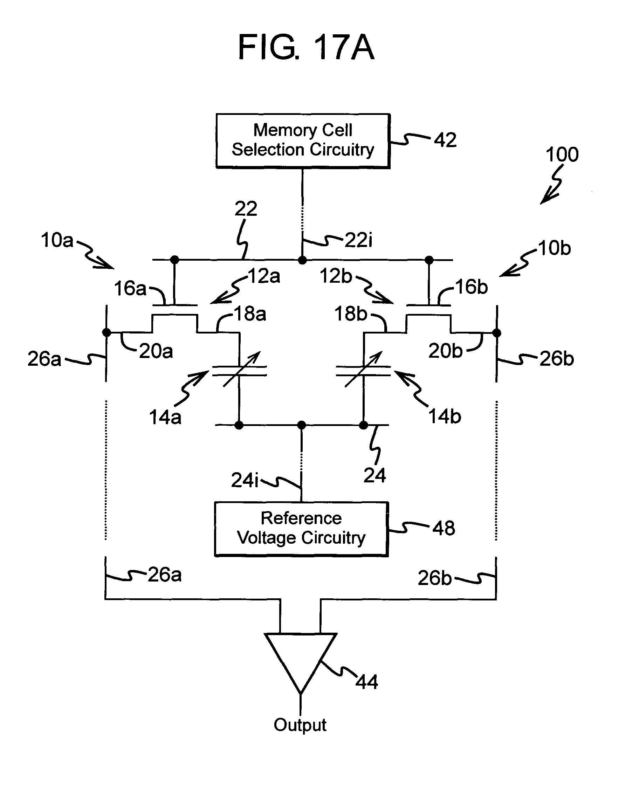

With continued reference to FIGURES 16 and 17A, the state of differential memory cell 100 may be read and/or determined by sense amplifier (comparator) 44, which may be a voltage or current type comparator (for example, a cross-coupled sense amplifier). In this regard, sense amplifier 44 compares a current or voltage (which depend on the resistive values stored or exhibited in electric field programmable bi-stable element 14a and 14b). The current or voltage sensed by sense amplifier 44 is indicative or representative of the different logic states stored in memory cell 10a and 10b.

Thus, differential memory cell 100 of this aspect of the present invention may include several advantages relative to memory cell 10 of the other aspects of the invention, including, for example: (i) the read operation is less sensitive to variation in the values of the binary states because a logic state is determined by the difference in states of the memory cells 10a and 10b, (ii) reference circuitry 46 of, for example, FIGURE 6, may not be necessary, and (iii) differential memory cell 100 may include a larger read window (as compared to memory cells described with respect to, for example, FIGURES 1A-C).

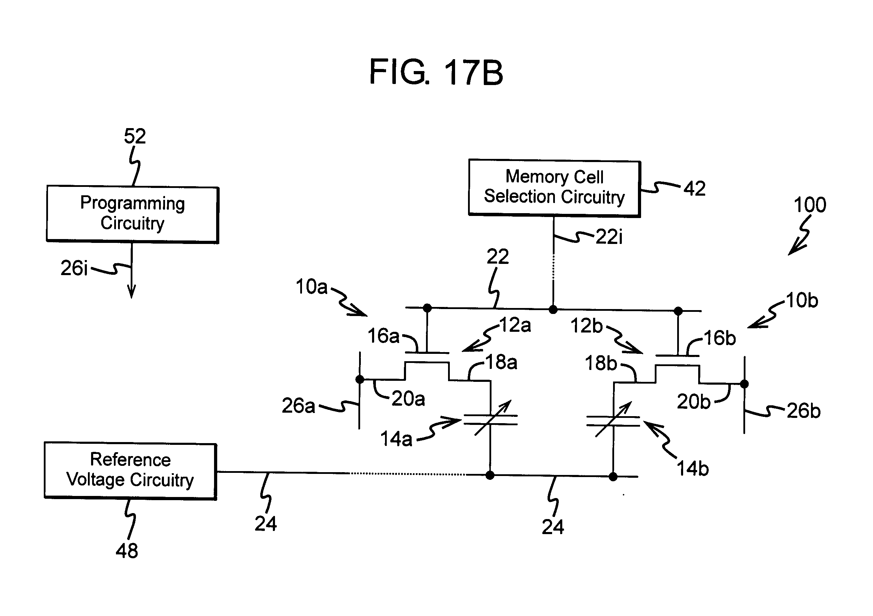

With reference to FIGURE 17B, in one embodiment, while access transistors 12a and 12b are "on", programming circuitry 52 applies (sequentially or concurrently) the appropriate voltage to store either a logic high or logic low. In this regard, with reference to FIGURE 2, providing or applying a voltage difference of approximately 4.5 volts across electric field programmable film 40 stores a logic high in electric field programmable bi-stable element 14. In contrast, providing or applying a voltage difference of approximately -2 volts across electric field programmable film erases the logic high, thereby storing a logic low in electric field programmable bi-stable element 14. This may be provided by applying such a voltage difference to electric field programmable bi-stable element 14 via control signal lines 24 and 26.

In one embodiment, memory cells 10a and 10b have the same or similar characteristics. In those instances where memory cells 10a and 10b are designed to have the same or similar characteristics, it may be advantageous to physically or spatially locate memory cells 10a and 10b near each other. In this way, during manufacturing, memory cells 10a and 10b are likely to be fabricated with little to no process variations or differences and, as such, (i) access transistor 12a and 12b of memory cells 10a and 10b, respectively, are likely to have the same or similar electrical, physical, doping concentration and/or profile characteristics, and (2) electric field programmable bi-stable element 14a and 14b of memory cells 10a and 10b, respectively, are likely to have the same or similar electrical characteristics. Indeed, memory cells 10a and 10b of memory cell 100 are likely to change over temperature and time in the same or similar way.

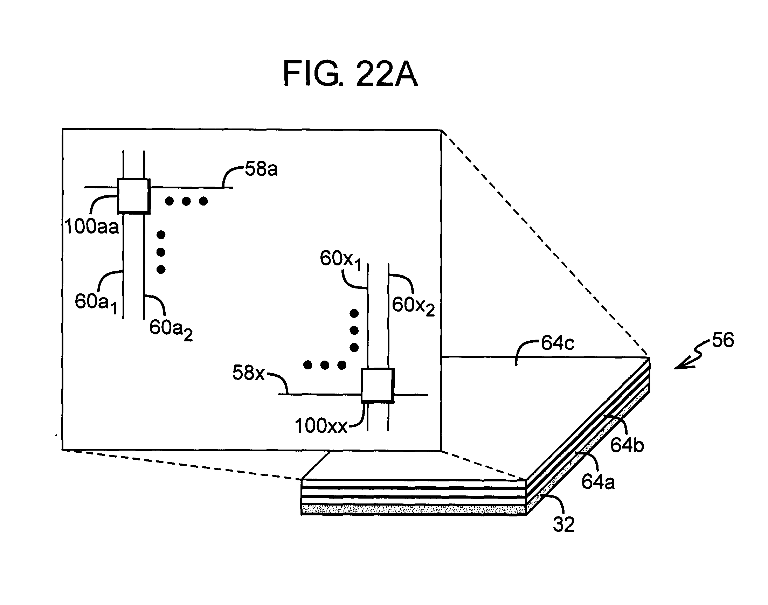

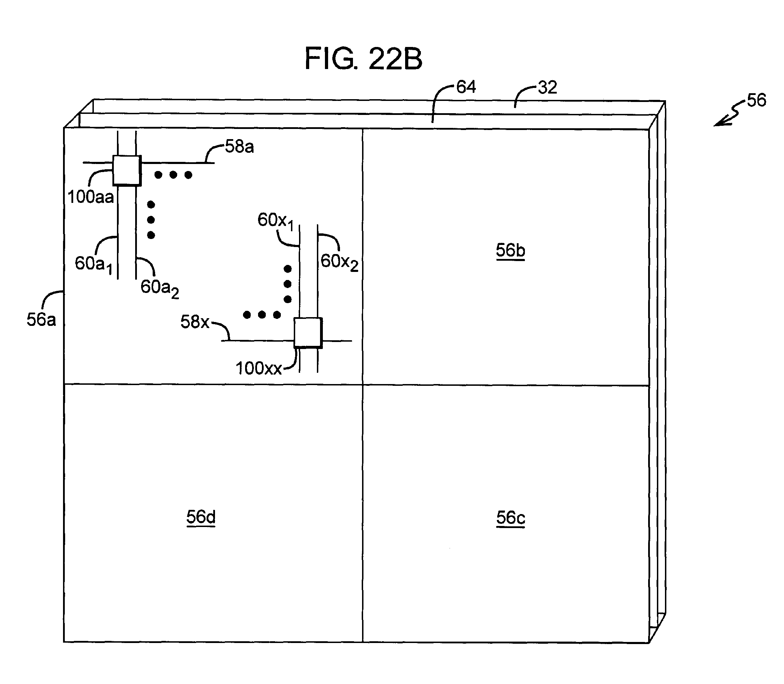

A memory device may include an array of differential memory cells 100 (i.e., a plurality of memory cells, arranged in repeating patterns). (See, for example, FIGURES 22A and 22B). The memory cells 100 may be arranged in an array in many different ways. For example, memory cells 100 may be fabricated in a stacked configuration, having a plurality of layers 64 which each include an electric field programmable bi-stable element coupled to a "shared" or common access transistor as described above with respect to the second aspect of the inventions. (See, FIGURE 22A). In this embodiment, each layer of electric field programmable film 40 (in conjunction with shared access transistor 12) "effectively" includes a plurality of memory cells 100aa-xx, having an access transistor 12 disposed in or on substrate 32 and electric field programmable bi-stable element 14 in one of the plurality of layers 64.

In one embodiment, differential memory cell 100 may include a first memory cell comprised of an access transistor and an electric field programmable bi-stable element disposed in first layer 64a. The memory cell 100 may include a second memory cell comprised of the same access transistor and an electric field programmable bi-stable element disposed in second layer 64b. (See, for example, the layouts of FIGURES 10A, 10B, 14A and 14B. In this way, the memory cells of differential memory cell 100 are located spatially near each other which may minimize, reduce or eliminate environment (i.e., temperature) and/or process variations between the first and second memory cells since each include a common access transistor and the electric field programmable bi-stable elements of differential memory cells 100 are located in adjacent layers 64.

In another embodiment, differential memory cell 100 may include (1) a first memory cell comprised of an access transistor and an electric field programmable bi-stable element disposed in first layer of electric field programmable film and (2) a second memory cell comprised of an access transistor that is adjacent to the access transistor of the first memory cell and an electric field programmable bi-stable element also disposed in first layer of electric field programmable film. In this way, the memory cells of differential memory cell 100 are located spatially near each other which, as mentioned above, may minimize, reduce or eliminate environment (i.e., temperature) and/or process variations between the constituent parts of first and second memory cells.

Moreover, as mentioned above, transistors 12 may be fabricated, formed, disposed and/or located in a plane or layer that is different than (for example, "higher") substrate 32. In this regard, transistors 12 may be fabricated from or in polysilicon, amorphous silicon or other non-crystalline material. Under this circumstance, a 3-dimensional array of memory may be fabricated wherein one or more layers (in addition to or in lieu of the substrate) may include transistors. (See, for example, layers 68 in FIGURES 23A-23C). As such, electric field programmable bi-stable elements 14 may be formed, disposed and/or located in layers or planes that are above and/or below such transistors. (See, for example, FIGURES 23B and 23C).

Indeed, it may be advantageous to re-crystallize a polysilicon layer disposed above the substrate in order to enhance the operating characteristics of a transistor disposed or fabricated therein. In this way, a 3-dimensional array of memory may include one or more monocrystalline silicon or semiconductor layers (in addition to or in lieu of the substrate) having transistors disposed or fabricated in such layers.

Notably, memory cells 100 of the memory device may also be fabricated in a non-stacked configuration, having an electric field programmable bi-stable element, disposed a single layer 64, coupled to an associated access transistor which is disposed in substrate 32. (See, FIGURE 22B).

All layout configurations for access transistor in relation to associated electric field programmable bi-stable element(s), whether now known or later developed, are intended to be within the present invention. (See, for example, FIGURES 16 and 18A-18C). For example, in one layout, memory cells 10a and 10b are configured to have separate sense lines 24a and 24b, respectively. (Compare FIGURES 16 and 18A).

In another embodiment, differential memory cell may include plurality of memory cells, comprised of one access transistor and two or more electric field programmable bi-stable element 14, configured to store complementary data states. In this regard, with reference to FIGURE 19, differential memory cell 100 includes first memory cell 10a and second memory cell 10b wherein first memory cell 10a maintains a complementary state relative to second memory cell 10b. The memory cells 10a and 10b "share" access transistor 12. In addition, memory cells 10a and 10b each include electric field programmable bi-stable elements 14a and 14b, respectively.

Notably, differential memory cell 100 of FIGURE 19 presents a more dense or compact memory cell (due to the sharing of the access transistor) than memory cell 100 illustrated in FIGURE 16.

With continued reference to FIGURE 19, memory cells 10a and 10b of differential memory cell 100 may be manufactured, configured and/or controlled as described and illustrated with respect to any of the embodiments of any of the aspects of the present inventions described herein. Moreover, memory cells 10a and 10b may include a layout and configuration as described and illustrated with respect to any of the embodiments of any of the aspects of the present inventions described herein. (See, for example, FIGURES 9-18C). In this regard, electric field programmable bi-stable elements 14a and 14b may be connected to gate 16, drain 20, or as illustrated in FIGURE 19, source 18. For the sake of brevity, those details, discussions and illustrations will not be repeated.

The discussions pertaining to read, program and erase operations for differential memory cell 100 of FIGURE 16 are equally applicable to differential memory cell 100 illustrated in FIGURE 19. For the sake of brevity, those discussions will not be repeated, but will be briefly summarized.

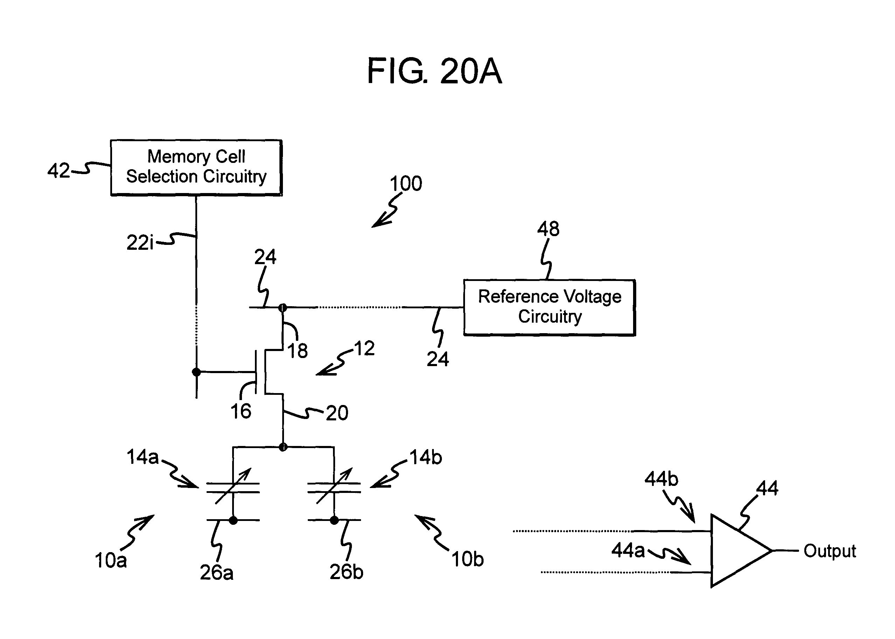

With reference to FIGURE 20A, the data state of the one transistor differential memory cell 100 may be read and/or determined by sampling, sensing measuring and/or detecting the logic states stored in each memory cell 10a and memory cell 10b. That is, memory cells 100 may be read by sampling, sensing, measuring and/or detecting the difference in the resistive values stored or exhibited in electric field programmable bi-stable element 14a and 14b. In this regard, in one exemplary embodiment, control signal line 22 is raised to Vpp (via memory selection circuitry 42) and control signal line 24 is maintained at 0V, a common voltage and/or reference voltage (via reference voltage circuitry 48) (See, for example, FIGURE 7A). The difference in resistive values may be sampled, sensed, measured and/or detected using current or voltage based techniques (via sense amplifier 44). Notably, in a first logic state of memory cell 100, memory cell 10a stores a logic low and memory cell 10b stores a logic high. In contrast, in a second logic state of differential memory cell 100, memory cell 10a stores a logic high and memory cell 10b stores a logic low.

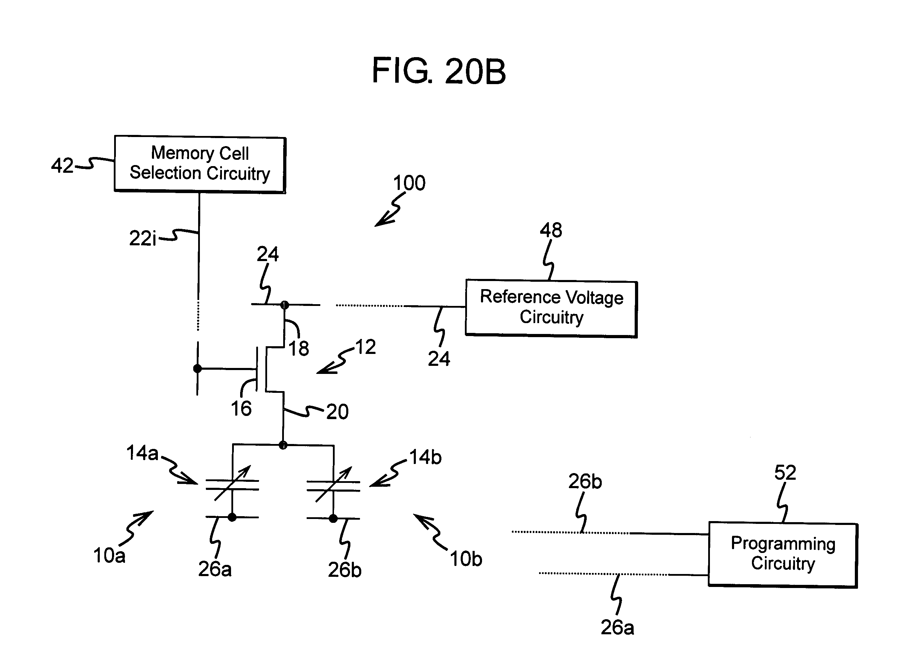

With reference to FIGURE 20B, in one embodiment, the data state of the one transistor differential memory cell 100 may be programmed and/or erased by turning "on" access transistor 12 (via memory selection circuitry 42 and reference voltage circuitry 48) and applying appropriate voltages to control signal lines 26a and 26b (via programming circuitry 52), sequentially or concurrently, to store either a logic high or logic low. For example, a logic high is stored in differential memory cell 100 in response to applying 4.5V to signal line 26a and 2.5V to signal line 26b, while applying V+ to gate 16 of transistor 12 (via memory selection circuitry 42) and 0V or a common voltage to source 18 (via reference voltage circuitry 48). In contrast a logic low is stored in differential memory cell 100 in response to applying 2.5V to signal line 26a and 4.5V to signal line 26b, while applying V+ to gate 16 of transistor 12 (via memory selection circuitry 42) and 0V to source 18 (via reference voltage circuitry 48).

Again, the discussions pertaining to read, program and erase operations for differential memory cell 100 of FIGURE 16 are equally applicable to differential memory cell 100 illustrated in FIGURE 19.

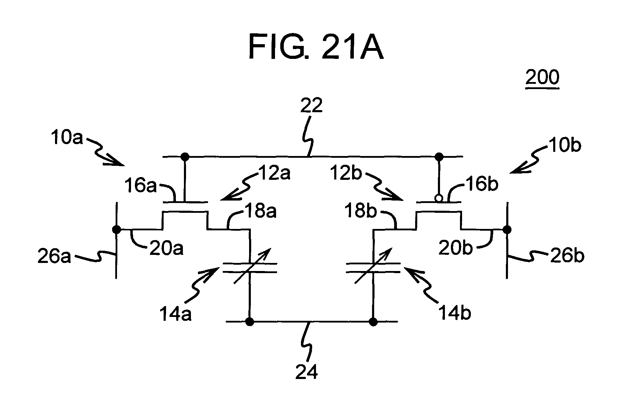

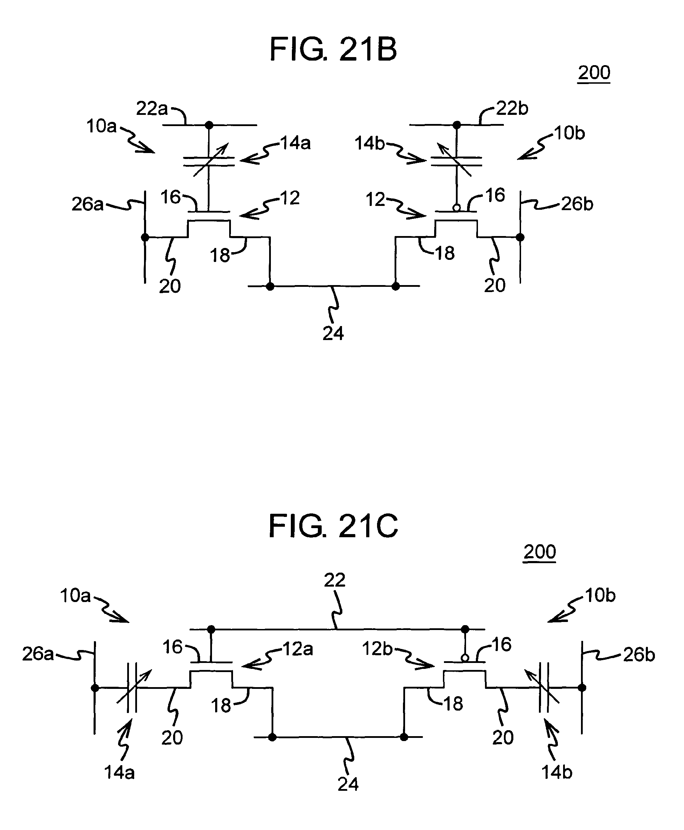

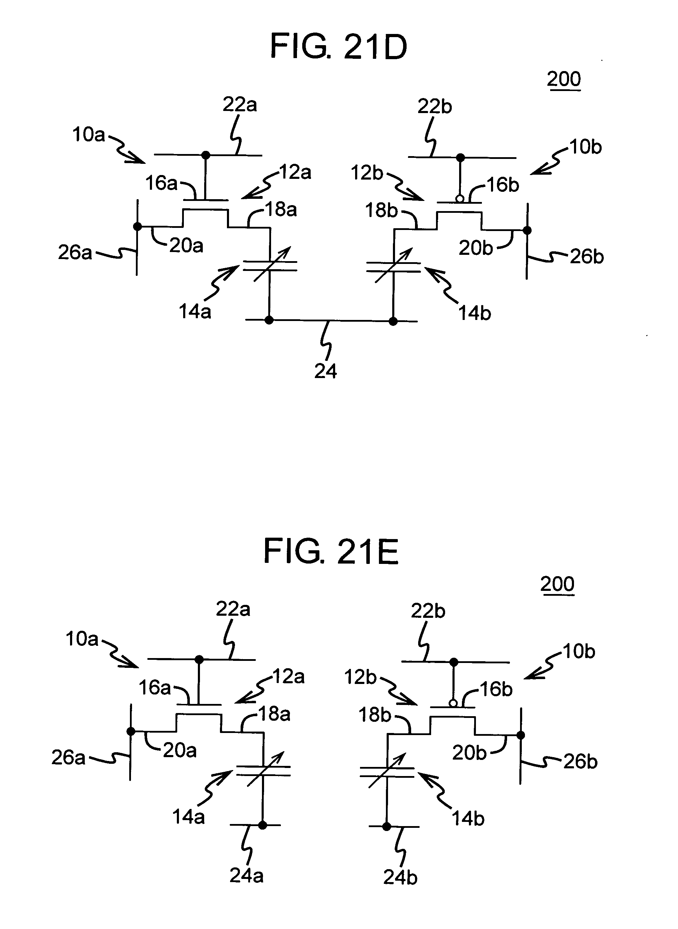

In another aspect, the present invention includes a complementary memory cell having an N-channel type memory cell and a P-channel type memory cell, which stores at least four different data states. In this regard, with reference to FIGURES 21A-21C, complementary memory cell 200 includes first memory cell 10a, having an N-channel access transistor 12a and electric field programmable bi-stable element 14a, and second memory cell 10b, having an P-channel access transistor 12b and electric field programmable bi-stable element 146. In this embodiment, gates 16a and 16b of N-channel access transistor 12a and P-channel access transistor 12b, respectively, are connected together and/or controlled by a common signal (word) line 22.

The memory cells 10a and 10b of complementary memory cell 200 may be manufactured, configured and/or controlled as described and illustrated with respect to any of the embodiments of any of the aspects of the present inventions described herein. Moreover, memory cells 10a and 10b may include a layout as described and illustrated with respect to any of the embodiments of any of the aspects of the present inventions described herein. For the sake of brevity, those details, discussions and illustrations will not be repeated.

Briefly, the data state of the two-transistor complementary memory cell 200 may be read and/or determined by sampling, sensing measuring and/or detecting the logic states stored in each memory cell 10 of complementary memory cell 200. That is, complementary memory cell 200 may be read by sampling, sensing, measuring and/or detecting the difference in the resistive values stored or exhibited in electric field programmable bi-stable element 14a and 14b.

The state of complementary memory cell 200 may be read and/or determined by a sense amplifier (comparator), which may be a voltage or current type comparator (for example, a cross-coupled sense amplifier). In this regard, sense amplifier compares a current or voltage of one of the memory cells 12a or 12b (which depend on the resistive values stored or exhibited in electric field programmable bi-stable element 14a and 14b) to a reference voltage or current (provided, for example, via reference circuitry 46). The current or voltage sensed by sense amplifier 44 is indicative or representative of the different logic states stored in memory cell 10a and 10b.

In particular, memory cell 10a may be read by raising applying Vpp to the gate of access transistor 12a (via control signal line 22) to turn "on" transistor 12a. In this way, the resistance of electric field programmable film 14a may be sensed by sense amplifier 44. The memory cell 12b may be read by turning "on" transistor 12b via applying a low voltage (for example, 0 volts or ground/common) to the gate of access transistor 12b. In this way, the resistance of electric field programmable film 14b may be sensed by sense amplifier 44.

The state of complementary memory cell 200 may be written or erased via programming circuitry 52 by applying appropriate voltage to store either a logic high or logic low while one of the access transistors 12a and 12b is "on". In this regard, control signal line 22 may be raised to Vpp to turn "on" access transistor 12a and, with reference to FIGURE 2, a logic high may be stored in electric field programmable bi-stable element 14a by providing or applying a voltage difference of approximately 4.5 volts across electric field programmable film 40. In contrast, providing or applying a reverse voltage difference of approximately 2 volts across electric field programmable film 14a (while transistor 12a is "on") erases the logic high, thereby storing a logic low in electric field programmable bi-stable element 14a. A voltage difference of 2 volts may be provided by controlling the voltages applied to control signal lines 24 and 26.

A logic high may be stored in electric field programmable bi-stable element 14b by applying a sufficiently low voltage (for example, 0 volts) to gate 16b of access transistor 12b (via control signal line 22) to turn "on" access transistor 12b, and providing or applying a voltage difference of approximately 4.5 volts across electric field programmable film 40. (See, FIGURE 2). Alternatively, a logic low may be stored (or a logic high is erased) in electric field programmable bi-stable element 14b by providing or applying a voltage difference of approximately 2 volts across electric field programmable film 14b (while transistor 12b is "on"). As mentioned above, a voltage difference of 2 volts may be provided by controlling the voltages applied to control signal lines 24 and 26.

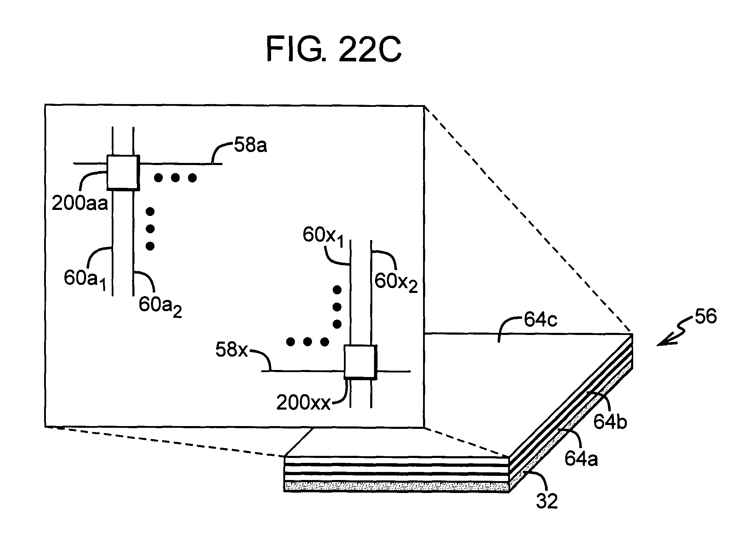

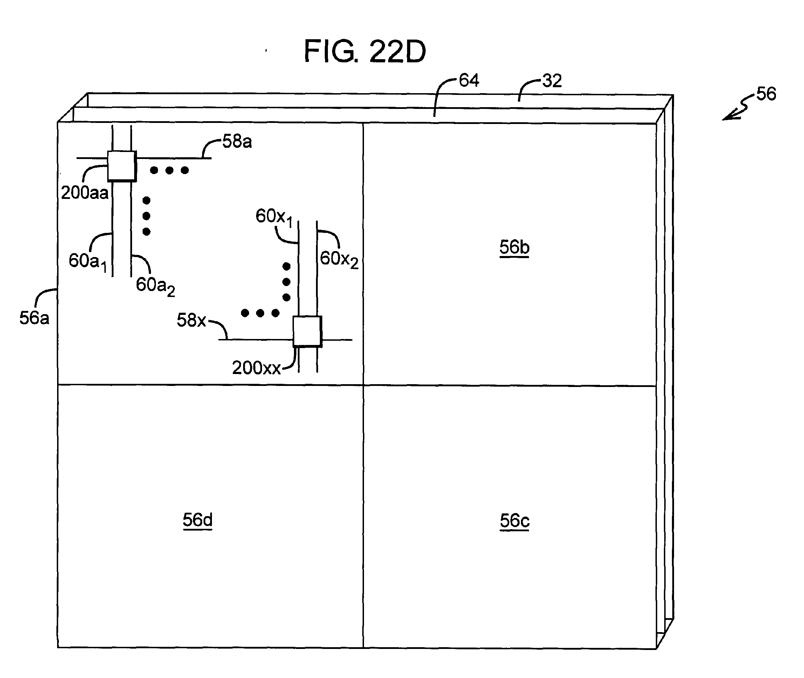

Like the memory device having an array of differential memory cells 100 described above, a memory device may include an array of complementary memory cell 200 (i.e., a plurality of memory cells, arranged in repeating patterns). (See, for example, FIGURES 22C and 22D). The complementary memory cell 200 may be arranged in an array in many different ways. For example, complementary memory cell 200 may be fabricated in a stacked configuration, having a plurality of layers 64 which each include an electric field programmable bi-stable element coupled to a corresponding access transistor as described above with respect to the second aspect of the inventions. (See, FIGURE 22C). In this embodiment, each layer of electric field programmable film 40 (in conjunction with access transistor 12) "effectively" includes a plurality of memory cells 200aa-xx, having an access transistor 12 (both N-channel and P-channel) disposed in or on substrate 32 and electric field programmable bi-stable element 14 in one of the plurality of layers 64.

Moreover, as mentioned above, transistors 12 may be fabricated, formed, disposed and/or located in a plane or layer that is different than (for example, "higher") substrate 32. In this regard, the transistors 12 may be fabricated from or in polysilicon, amorphous silicon or other non-crystalline material. Under this circumstance, a 3-dimensional array of memory may be fabricated wherein one or more layers (in addition to or in lieu of the substrate) may include transistors. (See, for example, layers 68 in FIGURES 23A-C). As such, electric field programmable bi-stable elements 14 may be formed, disposed and/or located in layers or planes that are above and/or below such transistors. Moreover, it may be advantageous to fabricate the N-channel access transistors in one layer or more layers (for example, in substrate 32, or above or below substrate 32) and the P-channel access transistors in one or more different layers (for example, in substrate 32, or above or below substrate 32).

Notably, memory cells 200 of the memory device may also be fabricated in a non-stacked configuration, having its electric field programmable bi-stable elements, disposed in a single layer 64, coupled to associated access transistors which are disposed in substrate 32. (See, FIGURE 22D). All layout configurations for access transistors (either N-channel or P-channel type access transistors) in relation to associated electric field programmable bi-stable element(s), whether now known or later developed, are intended to be within the present invention. (See, for example, FIGURES 21A-21E).

While certain embodiments, features, materials, configurations, attributes and advantages of the inventions have been described and illustrated, it should be understood that many other, as well as different and/or similar embodiments, features, materials, configurations, attributes, structures and advantages of the present inventions that are apparent from the description, illustration and claims. As such, the embodiments, features, materials, configurations, attributes, structures and advantages of the inventions described and illustrated herein are not exhaustive and it should be understood that such other, similar, as well as different, embodiments, features, materials, configurations, attributes, structures and advantages of the present inventions are within the scope of the present invention.

For example, electric field programmable film 40 of the memory cells 10 (and memory cell 100) described above may be comprised of a plurality of films. That is, electric field programmable film 40 may include two separate/layered electric field programmable films that are described in Electric Field Programmable Films Patent Application.

Moreover, while a significant portion of this description includes details (for example, erase, write, and read voltages) directed to N-channel access transistors, the inventions (and embodiments thereof) described herein are entirely applicable to P-channel access transistors. Moreover, the circuitry that is peripheral to the memory array (for example, word line decoders/drivers, not illustrated herein, as well as comparators) may include P-channel and/or N-channel type transistors. The voltages to control such transistors are well known in the art in light of this disclosure. Accordingly, for sake of brevity, these discussions will not be repeated.

Further, as mentioned above, there are many different techniques (and circuitry to implement such techniques) to read data from and write data into memory cells 10 and memory cells 100. All such techniques, and circuitry therefore, whether now known or later developed, are intended to fall within the scope of the present invention. For example, the read and write, or read and erase operations may be performed sequentially, in parallel (and independently) for electric field programmable bi-stable element 14a and/or 14b of memory cell 100 of FIGURES 17A and 17B, by including separate word signal lines 22.

As mentioned above, the transistors and electrodes may be fabricated using standard fabrication techniques (for example, spin-on, sputtering, evaporation, and photolithography). However, non-standard fabrication techniques may also be employed. Such non-standard or non-traditional techniques may be advantageous to create, provide and/or form the electrically programmable film and electrode structures. For example, nano-imprinting, patch die coating, slot or extrusion coating, slide or cascade coating, curtain coating, roll coating such as knife over roll (doctor blade) coating, forward and reverse roll coating, gravure coating, dip coating, spray coating, meniscus coating, spin coating, brush coating, air knife coating, silk screen printing processes, electrostatic printing processes, thermal printing processes, ink jet printing processes, direct transfer such as laser assisted ablation from a carrier, self-assembly or direct growth, electrodeposition, electroless deposition, electropolymerization, CVD, MOCVD, and PVD are all techniques whereby an electrode and/or an electric field programmable film may be advantageously deposited, formed, structured, patterned and/or provided.

Further structuring or patterning electrodes and/or an electric field programmable film may be implemented and/or obtained through patterning by liftoff techniques, or by chemical, physical, electrical, or photolytic etching, removal, or ablation (such as laser ablation). Indeed, the type, composition, deposition, formation, structuring, patterning and modification of the electrode(s), the electrode material(s), and the electric field programmable film may affect the performance of the resultant device. As such, from a performance and reliability perspective, it may be advantageous to select from a range of electrode materials, such as organic materials, inorganic materials, organometallics, metals, metal oxides, nitrides, chalcogenides, and pnictides, and semiconductors.

It may further be advantageous to modify, adjust and/or control the interface between the electrode and the electric field programmable film in one or more ways, for example, (1) by chemically modifying the surface of the electrode, the electric field programmable film, or both, and/or (2) by physically modifying the surface of the electrode, the electric field programmable film, or both, and/or (3) by introducing one or more additional layers which may modify the physical characteristics of the contact between the electrode and the electric field programmable film, such as a tie layer, a diffusion barrier, and/or a buffer layer, and/or by introducing one or more additional layers which may modify the electrical characteristics of the contact between the electrode and the electric field programmable film, such as a metal or metal oxide layer with a specific work function.

Moreover, the electric field programmable film and/or the electrode may have additional materials incorporated into them to improve, enhance and/or change certain characteristics of the interface, such as flow and wetting aids, adhesion promoters, and/or corrosion inhibitors. The material selections and modifications may advantageously serve to improve such properties as chemical, physical, mechanical, thermal, or electrical compatibility, thereby improving the performance of the device.

As mentioned above, transistor 12 may be fabricated from or in any semi-conducting material, including, for example, silicon carbide, gallium arsenide, or an organic material such as pentacene. (See, for example, layers 68 in FIGURES 23A-C). All methods of fabricating transistor 12 (and materials used therein), whether now known or later developed, are intended to be within the scope of the present invention. For example, transistors 12 may be fabricated in polysilicon or amorphous silicon. Such a configuration may facilitate a 3-dimensional array of memory wherein one or more layers (in addition to or in lieu of the substrate) disposed above substrate 32 may include transistors 12. Indeed, it may be advantageous to re-crystallize a polysilicon layer disposed above substrate 32 in order to enhance the operating characteristics or increase the density of transistors 12 that are disposed or fabricated therein.

Moreover, in another embodiment, thin monocrystalline wafers may be bonded together to provide a plurality of 3-dimensional array of memory having transistors disposed or fabricated in layers "above" or spaced from a "substrate". The electric field programmable bistable element 14 (including electrodes 38 and electric field programmable film 40) may be disposed in or between such thin monocrystalline wafers (containing N-channel and/or P-channel transistors) to provide a 3-dimensional array of memory.

It should be further noted that the term "circuit" may mean, among other things, a single component or a multiplicity of components (whether in integrated circuit form or otherwise), which are active and/or passive, and which are coupled together to provide or perform a desired function. The term "circuitry" may mean, among other things, a circuit (whether integrated or otherwise), a group of such circuits, a processor(s), a processor(s) implementing software, or a combination of a circuit (whether integrated or otherwise), a group of such circuits, a processor(s) and/or a processor(s) implementing software, processor(s) and circuit(s), and/or processor(s) and circuit(s) implementing software. The term "data" may mean, among other things, a current or voltage signal(s) whether in an analog or a digital form. The term "measure" means, among other things, sample, sense, inspect, detect, monitor and/or capture. The phrases "to sample" or "sample(s)" or the like, may mean, among other things, to record, to measure, to detect, to monitor, and/or to sense.

## Claims

1. A memory cell having at least a first data state and a second data state, the memory cell comprising:
a semiconductor transistor including:
a first region having impurities to provide a first conductivity type;
a second region having impurities to provide a first conductivity type;
a body region disposed between the first region and the second region, wherein the body region includes impurities to provide a second conductivity type wherein the second conductivity type is different from the first conductivity type; and
a gate, spaced from, and electrically coupled to the body region; and
an electric field programmable bi-stable element, connected to the semiconductor transistor, the electric field programmable bi-stable element including:
a first electrode;
a second electrode; and
at least one electric field programmable film disposed between the first and second electrodes wherein the first data state of the memory cell is representative of a first resistance of the electric field programmable film and the second data state is representative of a second resistance of the electric field programmable film.

2. The memory cell of claim 1 wherein the first region is a drain region of the semiconductor transistor and wherein the first electrode is connected to the drain region.

3. The memory cell of claim 1 wherein the second region is a source region of the semiconductor transistor and wherein the first electrode is connected to the source region.

4. The memory cell of claim 1 wherein the first electrode is connected to the gate of the semiconductor transistor.

5. A memory cell including a plurality of electric field programmable bi-stable elements, the memory cell having at least a first data state and a second data state, the memory cell comprising:
a semiconductor transistor including:
a first region having impurities to provide a first conductivity type;
a second region having impurities to provide a first conductivity type;
a body region disposed between the first region and the second region, wherein the body region includes impurities to provide a second conductivity type wherein the second conductivity type is different from the first conductivity type; and
a gate, spaced from, and electrically coupled to the body region;
a first electric field programmable bi-stable element, connected to the semiconductor transistor, the electric field programmable bi-stable element including:
a first electrode;
a second electrode; and
at least one electric field programmable film disposed between the first and second electrodes wherein the electric field programmable film includes at least two resistance states, including a first resistance state and a second resistance state;
a second electric field programmable bi-stable element, connected to the semiconductor transistor, the electric field programmable bi-stable element including
a first electrode;
a second electrode; and
at least one electric field programmable film disposed between the first and second electrodes wherein the electric field programmable film includes at least two resistance states, including a first resistance state and a second resistance state; and
wherein the memory cell is in: (1) the first data state when the electric field programmable film of the first electric field programmable bi-stable element is in the first state and the electric field programmable film of the second electric field programmable bi-stable element is in the second state and (2) the second data state when the electric field programmable film of the first electric field programmable bi-stable element is in the second state and the electric field programmable film of the second electric field programmable bi-stable element is in the first state.

6. The memory cell of claim 5 wherein the memory cell includes third and fourth data states and wherein:
the memory cell is in the third data state when the electric field programmable film of the first electric field programmable bi-stable element is in the first state and the electric field programmable film of the second electric field programmable bi-stable element is in the first state; and
the memory cell is in the fourth data state when the electric field programmable film of the first electric field programmable bi-stable element is in the second state and the electric field programmable film of the second electric field programmable bi-stable element is in the second state.

7. A memory cell including a plurality of semiconductor transistors and a plurality of electric field programmable bi-stable elements, the memory cell having at least a first data state and a second data state, the memory cell comprising:
a first semiconductor transistor including:
a first region having impurities to provide a first conductivity type;
a second region having impurities to provide a first conductivity type;
a body region disposed between the first region and the second region, wherein the body region of the first semiconductor transistor includes impurities to provide a second conductivity type wherein the second conductivity type is different from the first conductivity type; and
a gate, spaced from, and electrically coupled to the body region of the first semiconductor transistor;
a first electric field programmable bi-stable element, connected to the first semiconductor transistor, the electric field programmable bi-stable element including:
a first electrode;
a second electrode; and
at least one electric field programmable film disposed between the first and second electrodes wherein the electric field programmable film includes at least two resistance states, including a first resistance state and a second resistance state;
a second semiconductor transistor including:
a first region having impurities to provide a third conductivity type;
a second region having impurities to provide a third conductivity type;
a body region disposed between the first region and the second region, wherein the body region of the second semiconductor transistor includes impurities to provide a fourth conductivity type wherein the fourth conductivity type is different from the third conductivity type; and
a gate, spaced from, and electrically coupled to the body region of the second semiconductor transistor;
a second electric field programmable bi-stable element, connected to the second semiconductor transistor, the electric field programmable bi-stable element including:
a first electrode;
a second electrode; and
at least one electric field programmable film disposed between the first and second electrodes of the second electric field programmable bi-stable element wherein the electric field programmable film of the second electric field programmable bi-stable element includes at least two resistance states, including a first resistance state and a second resistance state; and
wherein the memory cell is in: (1) the first data state when the electric field programmable film of the first electric field programmable bi-stable element is in the first state and the electric field programmable film of the second electric field programmable bi-stable element is in the second state, and (2) the second data state when the electric field programmable film of the first electric field programmable bi-stable element is in the second state and the electric field programmable film of the second electric field programmable bi-stable element is in the first state.

8. The memory cell of claim 7 wherein the body region of the first semiconductor transistor is an N-type semiconductor material and the body region of the second transistor is a P-type semiconductor material.

9. The memory cell of claim 7 wherein the body region of the first semiconductor transistor is an N-type semiconductor material and the body region of the second transistor is an N-type semiconductor material.

10. The memory cell of claim 7 wherein the body region of the first semiconductor transistor is a P-type semiconductor material and the body region of the second transistor is a P-type semiconductor material.

11. The memory cell of claim 7 wherein the memory cell includes third and fourth data states and wherein:
the memory cell is in the third data state when the electric field programmable film of the first electric field programmable bi-stable element is in the second state and the electric field programmable film of the second electric field programmable bi-stable element is in the second state; and
the memory cell is in the fourth data state when the electric field programmable film of the first electric field programmable bi-stable element is in the first state and the electric field programmable film of the second electric field programmable bi-stable element is in the first state.
